# EUROPEAN PATENT APPLICATION

(11) **EP 4 770 299 A1**
(43) Date of publication of application: **01.07.2026**
(21) Application number: 24867086.1
(22) Date of filing: 24.07.2024
(51) Int. Cl.: H05K 9/00

(54) **ELECTROMAGNETIC PROTECTION STRUCTURE AND ELECTRONIC DEVICE**

(30) Priority: 21.09.2023 CN 202311231887
(71) Applicant: Honor Device Co., Ltd., Shenzhen, Guangdong 518040 (CN)
(72) Inventor: YIN, Ming, Shenzhen, Guangdong 518040 (CN); CHEN, Xu, Shenzhen, Guangdong 518040 (CN); WU, Dong, Shenzhen, Guangdong 518040 (CN)
(74) Representative: Goddar, Heinz J.
(86) International application number: PCT/CN2024/107241
(87) International publication number: WO 2025/060669

(57) **Abstract**

Embodiments of this application provide an electromagnetic protection structure and an electronic device. The electromagnetic protection structure includes: a first structural member, where the first structural member includes a radio frequency source; a second structural member, where a first current path is coupled between the second structural member and the first structural member, the first current path includes a non-linear region, and when a coupling current of the radio frequency source passes through the non-linear region, a non-linear effect is generated in the non-linear region; and a conductive medium, where the conductive medium is electrically connected to the first structural member and the second structural member to form a second current path between the second structural member and the first structural member, so that at least a part of the coupling current of the radio frequency source flows from the first structural member to the second structural member through the second current path. In embodiments of this application, the second current path formed by the conductive medium can shunt the first current path, so as to eliminate or weaken a non-linear effect on the first current path, thereby resolving an electromagnetic compatibility problem of the electronic device caused by the non-linear effect.

## Description

This application claims priority to Chinese Patent Application No. 202311231887.0, filed with the China National Intellectual Property Administration on September 21, 2023 and entitled "ELECTROMAGNETIC PROTECTION STRUCTURE AND ELECTRONIC DEVICE", which is incorporated herein by reference in its entirety.

### TECHNICAL FIELD

This application relates to the field of terminal technologies, and in particular, to an electromagnetic protection structure and an electronic device.

### BACKGROUND

An electronic device such as a mobile phone, a tablet computer, and a personal computer usually includes some assemblies with complex structures. For example, a foldable-screen mobile phone includes a rotary shaft assembly to implement folding of a body, and a mobile phone with a liftable camera module includes a lifting assembly to implement lifting of the camera module.

Each assembly may include one or more components to implement a function of the assembly. Different contact manners, for example, stable contact or unstable contact, may exist between the components, and between the component and another structure of the electronic device. The stable contact means that relative displacement does not occur between two components in contact, and the unstable contact means that relative displacement may occur between two components in contact.

The electronic device may include a radio frequency component such as an antenna to implement a wireless communication function. When the antenna emits an electromagnetic wave signal, a coupling current is generated on a conductive component around the antenna, and the coupling current is transmitted between conductive components inside the electronic device. When flowing through components in unstable contact, the coupling current generates a non-linear effect in a contact region of the components, and the non-linear effect causes an electromagnetic compatibility problem of the electronic device.

### SUMMARY

Embodiments of this application provide an electromagnetic protection structure and an electronic device, to resolve an electromagnetic compatibility problem of the electronic device such as a mobile phone that is caused by a non-linear effect.

According to a first aspect, an embodiment of this application provides an electromagnetic protection structure. The electromagnetic protection structure includes a first structural member, a second structural member, and a conductive medium. The first structural member may include a radio frequency source, and the radio frequency source may be a component that can generate an electromagnetic wave such as an antenna. When receiving or transmitting the electromagnetic wave, the radio frequency source generates a coupling current in the first structural member. A first current path is coupled between the second structural member and the first structural member, the first current path includes a non-linear region, and when a coupling current passes through the non-linear region, a non-linear effect is generated. The conductive medium is electrically connected to the first structural member and the second structural member to form a second current path between the second structural member and the first structural member, so that at least a part of the coupling current of the radio frequency source flows from the first structural member to the second structural member through the second current path.

It can be learned that, in this embodiment of this application, the second current path formed by the conductive medium can shunt the first current path, so as to eliminate or weaken a non-linear effect on the first current path, thereby resolving an electromagnetic compatibility problem of the electronic device caused by the non-linear effect.

In an implementation, the non-linear region includes an unstable contact region between at least two components on the first current path, and relative displacement is capable of being generated between the at least two components forming the unstable contact region.

In an implementation, the electromagnetic protection structure further includes a first connecting member, and the first connecting member is electrically connected to the first structural member and the second structural member to form the first current path. The non-linear region includes an unstable contact region between at least two components in the first connecting member, and/or an unstable contact region between the first connecting member and the first structural member, and/or an unstable contact region between the first connecting member and the second structural member. The first connecting member may be, for example, a rotary shaft assembly in a foldable-screen electronic device or a lifting assembly in an electronic device with a liftable camera module. A current path formed by the first connecting member serves as the first current path, and the second current path formed by the conductive medium is used for shunting, so that a non-linear effect on the rotary shaft assembly or the lifting assembly can be eliminated or weakened.

In an implementation, the conductive medium covers surfaces of the first structural member, the second structural member, and the first connecting member. In this way, an electrical connection may also be formed between the conductive medium and the first connecting member, and a current in the first connecting member is further shunted away, so as to improve a shunting effect of the second current path.

In an implementation, a distance between the conductive medium and an edge of the first structural member is less than a distance between the first connecting member and the edge of the first structural member. In such a structure, a length of the second current path is shorter than a length of the first current path, and impedance of the second current path is also lower than that of the first current path, which helps improve a shunting effect of the conductive medium.

In an implementation, the electromagnetic protection structure is used in a foldable-screen electronic device. The foldable-screen electronic device includes a first middle frame, a second middle frame, and a rotary shaft assembly. The first middle frame and the second middle frame are distributed on two sides of the rotary shaft assembly. The first middle frame and the second middle frame are separately connected to the rotary shaft assembly. The non-linear region includes an unstable contact region between at least two components in the rotary shaft assembly. The electromagnetic protection structure is used in the foldable-screen electronic device, so that a coupling current on the rotary shaft assembly can be shunted, so as to eliminate or weaken a non-linear effect of the unstable contact region in the rotary shaft assembly, thereby resolving an electromagnetic compatibility problem of the foldable-screen electronic device caused by the non-linear effect.

In an implementation, the first structural member includes the first middle frame. The second structural member includes the second middle frame. The first connecting member includes the rotary shaft assembly. One end of the conductive medium is attached to the first middle frame, and the other end of the conductive medium is attached to the second middle frame. In this way, the conductive medium can shunt the coupling current on the rotary shaft assembly, so as to eliminate or weaken the non-linear effect of the unstable contact region in the rotary shaft assembly, thereby resolving the electromagnetic compatibility problem of the foldable-screen electronic device caused by the non-linear effect.

In an implementation, the rotary shaft assembly includes a rotary shaft body, a first rotating structure, and a second rotating structure. The first rotating structure is located in the rotary shaft body. One end of the first connecting structure is connected to the first middle frame, and the other end of the first connecting structure is connected to the first rotating structure. The non-linear region includes an unstable contact region between at least two components in the first rotating structure, and\or an unstable contact region between the first rotating structure and the first connecting structure. The first structural member includes the first middle frame. The second structural member includes the rotary shaft body. The first connecting member includes the first rotating structure and the first connecting structure. One end of the conductive medium is attached to the first middle frame, and the other end of the conductive medium is attached to the rotary shaft body. In this way, the conductive medium can shunt a coupling current on the first rotating structure and the first connecting structure, so as to eliminate or weaken a non-linear effect of the unstable contact region in the first rotating structure and the first connecting structure, thereby resolving the electromagnetic compatibility problem of the foldable-screen electronic device caused by the non-linear effect.

In an implementation, the rotary shaft assembly includes a rotary shaft body, a door panel, a second connecting structure, and a third connecting structure. One end of the second connecting structure is connected to the first middle frame, and the other end of the second connecting structure is connected to the door panel. One end of the third connecting structure is connected to the door panel, and the other end of the third connecting structure is connected to the rotary shaft body. The non-linear region includes an unstable contact region between the second connecting structure and the door panel, and/or an unstable contact region between the third connecting structure and the door panel. The first structural member includes the first middle frame. The second structural member includes the rotary shaft body. The first connecting member includes the door panel, the second connecting structure, and the third connecting structure. One end of the conductive medium is attached to the first middle frame, and the other end of the conductive medium is attached to the rotary shaft body. In this way, the conductive medium can shunt a coupling current on the door panel, the second connecting structure, and the third connecting structure, so as to eliminate or weaken a non-linear effect of the non-linear contact region in the door panel, the second connecting structure, and the third connecting structure, thereby resolving an electromagnetic compatibility problem of the foldable-screen electronic device caused by the non-linear effect.

In an implementation, the first structural member includes the first middle frame. The second structural member includes the second middle frame. The first connecting member includes the rotary shaft assembly. The conductive medium includes a support plate of a foldable screen, a conductive filler is filled between the support plate and the first middle frame and between the support plate and the second middle frame, and the support plate is electrically connected to the first middle frame and the second middle frame separately by using the conductive filler. In this way, as a conductive medium, the support plate can shunt a coupling current on the rotary shaft assembly, so as to eliminate or weaken a non-linear effect of the unstable contact region in the rotary shaft assembly, thereby resolving an electromagnetic compatibility problem of the foldable-screen electronic device caused by the non-linear effect.

In an implementation, the electromagnetic protection structure is used in an electronic device that includes a lifting assembly. The electronic device includes a middle frame, a lifting assembly, and a drive structure. One end of the drive structure is connected to the middle frame, and the other end of the drive structure is connected to the lifting assembly. The non-linear region includes: an unstable contact region between at least two components in the drive structure, and/or an unstable contact region between the drive structure and the middle frame, and/or an unstable contact region between the drive structure and the lifting assembly. The electromagnetic protection structure is used in an electronic device that includes a lifting assembly, and can shunt a coupling current on the drive structure, so as to eliminate or weaken a non-linear effect of the unstable contact region in the drive structure, thereby resolving an electromagnetic compatibility problem of the electronic device that includes the lifting assembly caused by the non-linear effect.

In an implementation, the first structural member includes the middle frame. The second structural member includes the lifting assembly.

The first connecting member includes the drive structure. One end of the conductive medium is attached to a side that is of the middle frame and that is close to the radio frequency source, and the other end of the conductive medium is attached to the lifting assembly; or one end of the conductive medium is attached to a side that is of the middle frame and that is close to the radio frequency source, and the other end of the conductive medium spans across the lifting assembly, and is attached to a side that is of the middle frame and that is far away from the radio frequency source. In this way, the conductive medium can shunt the coupling current on the drive structure, so as to eliminate or weaken the non-linear effect of the unstable region in the drive structure, thereby resolving an electromagnetic compatibility problem of the electronic device with a lifting assembly caused by the non-linear effect.

In an implementation, the lifting assembly is a liftable camera module.

In an implementation, the first middle frame includes a first battery and first grounded metal, and the first battery is electrically connected to the first grounded metal. The second middle frame includes a second battery and second grounded metal, and the second battery is electrically connected to the second grounded metal. One end of the conductive medium is attached to the first grounded metal, and the other end of the conductive medium is attached to the second grounded metal. In this way, impedance between the first grounded metal and the second grounded metal is lower, and charging/discharging of the first battery and the second battery is more balanced.

In an implementation, the conductive medium includes a sheet-shaped conductive medium.

In an implementation, each of a contact area between the sheet-shaped conductive medium and the first structural member and a contact area between the sheet-shaped conductive medium and the second structural member is greater than 2 square millimeters. In this way, the contact area between the sheet-shaped conductive medium and the first structural member and the contact area between the sheet-shaped conductive medium and the second structural member are large enough to provide lower impedance.

In an implementation, a width of the sheet-shaped conductive medium is greater than 0.5 millimeter, and a thickness of the sheet-shaped conductive medium is less than 4 millimeters. In this way, the sheet-shaped conductive medium can have low impedance.

In an implementation, the sheet-shaped conductive medium is sheet-shaped metal.

In an implementation, a length of the second current path is less than a length of the first current path. In this way, the second current path can have low impedance.

In an implementation, impedance of the second current path is less than impedance of the first current path.

In an implementation, a height difference between the conductive medium and the first structural member or the second structural member is less than 5 millimeters. In this way, the sheet-shaped conductive medium can have low impedance.

According to a second aspect, an embodiment of this application provides an electronic device. The electronic device includes a first middle frame, a second middle frame, a rotary shaft assembly, a foldable screen, and a sheet-shaped conductive medium. The first middle frame includes a radio frequency source. The first middle frame and the second middle frame are distributed on two sides of the rotary shaft assembly, and are separately connected to the rotary shaft assembly. The foldable screen covers a same side of the first middle frame, the second middle frame, and the rotary shaft assembly. The first middle frame and the second middle frame are configured to be rotatable around the rotary shaft assembly to fold or unfold the foldable screen. A first current path is coupled between the first middle frame and the second middle frame through the rotary shaft assembly. The conductive medium is electrically connected to the first middle frame and the second middle frame to form a second current path between the first middle frame and the second middle frame, so that at least a part of a coupling current of the radio frequency source flows from the first middle frame to the second middle frame through the second current path.

According to a third aspect, an embodiment of this application provides an electronic device. The electronic device includes a middle frame, a lifting assembly, a drive structure, and a sheet-shaped conductive medium. The middle frame includes a radio frequency source and a cavity, and the lifting assembly is disposed in the cavity. One end of the drive structure is connected to the middle frame, and the other end of the drive structure is connected to the lifting assembly, to drive the lifting assembly to fall or rise, so that the lifting assembly is hidden in the cavity or at least partially protrudes from the cavity. A first current path is coupled between the middle frame and the lifting assembly through the drive structure. The conductive medium is electrically connected to the middle frame and the lifting assembly to form a second current path between the middle frame and the lifting assembly, so that at least a part of a coupling current of the radio frequency source flows from the middle frame to the lifting assembly through the second current path.

### BRIEF DESCRIPTION OF DRAWINGS

FIG. 1A is a schematic diagram of structures of foldable-screen mobile phones according to an embodiment of this application;
FIG. 1B is a scenario diagram of a non-linear effect inside a foldable-screen mobile phone according to an embodiment of this application;
FIG. 2 is a scenario diagram of another non-linear effect according to an embodiment of this application;
FIG. 3 is a scenario diagram of still another non-linear effect according to an embodiment of this application;
FIG. 4 is a schematic diagram of an electromagnetic protection structure according to an example embodiment of this application;
FIG. 5 is a view of the electromagnetic protection structure provided in FIG. 4 in a direction A;
FIG. 6 is a schematic diagram of another electromagnetic protection structure according to an example embodiment of this application;
FIG. 7 is a first schematic application diagram of an electromagnetic protection structure according to an example embodiment of this application;
FIG. 8 is a second schematic application diagram of an electromagnetic protection structure according to an example embodiment of this application;
FIG. 9 is a third schematic application diagram of an electromagnetic protection structure according to an example embodiment of this application;
FIG. 10 is an electromagnetic simulation diagram of an entire foldable-screen mobile phone according to an example embodiment of this application;
FIG. 11 is a schematic diagram of a shunting effect of a sheet-shaped conductive medium according to an example embodiment of this application;
FIG. 12 is a fourth schematic application diagram of an electromagnetic protection structure according to an example embodiment of this application;
FIG. 13 is a fifth schematic application diagram of an electromagnetic protection structure according to an example embodiment of this application;
FIG. 14 is a sixth schematic application diagram of an electromagnetic protection structure according to an example embodiment of this application;
FIG. 15 is a seventh schematic application diagram of an electromagnetic protection structure according to an example embodiment of this application;
FIG. 16 is an eighth schematic application diagram of an electromagnetic protection structure according to an example embodiment of this application;
FIG. 17 is a ninth schematic application diagram of an electromagnetic protection structure according to an example embodiment of this application;
FIG. 18 is a tenth schematic application diagram of an electromagnetic protection structure according to an example embodiment of this application;
FIG. 19 is an eleventh schematic application diagram of an electromagnetic protection structure according to an example embodiment of this application; and
FIG. 20 is a twelfth schematic application diagram of an electromagnetic protection structure according to an example embodiment of this application.

### DESCRIPTION OF EMBODIMENTS

An electronic device such as a mobile phone, a tablet computer, and a personal computer (personal computer, PC) usually includes some assemblies with complex structures. For example, a foldable-screen mobile phone includes a rotary shaft assembly to implement folding of a body, and a mobile phone with a liftable camera module includes a lifting assembly to implement lifting of the camera module.

To implement a function of each assembly, each assembly includes one or more components. For example, the rotary shaft assembly may include components such as a rotary shaft, a hinge, a door panel, a gear, a cam, a spring, a swing arm, and/or a slide rail. The lifting assembly may include components such as a motor, a screw, a slider, a rack, and a retractable lens tube. Different contact manners may exist between the components, and between the component and another part of the electronic device, for example, stable contact or unstable contact.

Generally, the stable contact means that relative displacement does not occur between two components in contact. Common manners of forming the stable contact include welding, riveting, adhesion, and screwing of the two components. For example, in the foldable-screen mobile phone, contact formed between a middle frame and a door panel of the rotary shaft assembly through screwing is the stable contact.

On the contrary, the unstable contact means that relative displacement may occur between two components in contact. The relative displacement may be any form of displacement between the two components, such as relative sliding, relative rotation, and being close to or far away from each other. Common manners of forming the unstable contact include slidable connection, hinging, abutment, engagement, rotary connection, and the like of the two components. For example, in the foldable-screen mobile phone, contact formed by hinging between the swing arm and the rotary shaft is unstable contact, contact formed by abutment between cams designed in pairs under the action of an elastic force of the spring is also unstable contact, and contact formed by mutual engagement between paired gears is also unstable contact. For another example, in the mobile phone with a liftable camera module, relative movable contact formed between the lifting assembly and the screw or the rack is also unstable contact.

The electronic device may include a radio frequency component such as an antenna to implement a wireless communication function, to emit or receive an electromagnetic wave signal. When the antenna emits an electromagnetic wave signal, a coupling current is generated on a conductive component around the antenna, and the coupling current is transmitted between conductive components inside the electronic device.

Generally, two components that form stable contact usually can provide a reliable electrical connection. Therefore, when the coupling current flows through the components in stable contact, a non-linear effect is generally not generated. On the contrary, two components that form unstable contact usually cannot provide a reliable electrical connection. Therefore, when the coupling current flows through the components in unstable contact, a non-linear effect is generated in a contact region of the components. The non-linear effect means that a relationship between a coupling current and a voltage does not follow a simple linear relationship at a junction of two components.

It should be further noted herein that the "electrical connection" in this embodiment of this application may include direct current conduction formed by direct contact between two components, or may include high-frequency coupling conduction formed by capacitive coupling of a specific area between the two components.

The non-linear effect brings a series of electromagnetic compatibility problems to the electronic device. Some related scenarios are listed below with reference to the accompanying drawings.

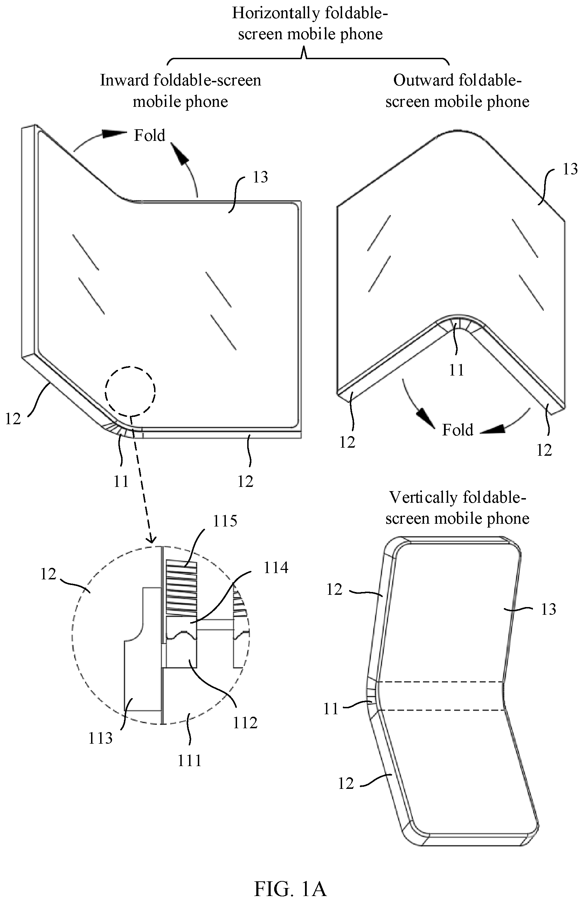

FIG. 1A is a schematic diagram of structures of foldable-screen mobile phones according to an embodiment of this application.

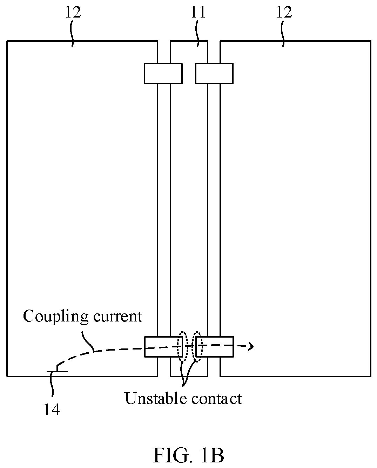

FIG. 1B is a scenario diagram of a non-linear effect inside a foldable-screen mobile phone according to an embodiment of this application.

Scenario 1: As shown in FIG. 1A and FIG. 1B, the foldable-screen mobile phones each generally include a rotary shaft assembly 11, two bodies 12 respectively disposed on two sides of the rotary shaft assembly 11, and a foldable screen 13 that covers a side of the two bodies 12 and the rotary shaft assembly 11. The foldable-screen mobile phones may include an inward foldable-screen mobile phone and an outward foldable-screen mobile phone based on different bending directions of the bodies of the foldable-screen mobile phones relative to the foldable screen 13. The inward foldable-screen mobile phone means that the body of the mobile phone may be folded toward a front surface of the foldable screen 13, where the front surface of the foldable screen 13 is a surface that is of the foldable screen 13 and that is used to display content. When the mobile phone is folded, the foldable screen 13 is hidden inside the body in a folded state, and when the mobile phone is unfolded, the foldable screen 13 is fully unfolded, to provide a large display range. The outward foldable-screen mobile phone means that the body 12 of the mobile phone may be folded toward a surface that is of the foldable screen 13 and that faces away from the front surface. When the mobile phone is folded, the foldable screen 13 is exposed around the body 12 in a folded state, and when the mobile phone is unfolded, the foldable screen 13 is fully unfolded, to provide a large display range.

In addition, the foldable-screen mobile phones may further include a horizontally foldable-screen mobile phone and a vertically foldable-screen mobile phone based on different distribution directions of the two bodies 12 of the foldable-screen mobile phones. In the inward foldable-screen mobile phone and the outward foldable-screen mobile phone shown in FIG. 1A, the two bodies 12 are distributed on left and right sides of the rotary shaft assembly 11, that is, the two bodies 12 are folded left and right in a width direction of the mobile phone, and such a foldable-screen mobile phone may be referred to as a horizontally foldable-screen mobile phone. Further, as shown in FIG. 1A, the two bodies 12 of the foldable-screen mobile phone may be further distributed on upper and lower sides of the rotary shaft assembly, that is, the two bodies 12 are folded up and down in a height direction of the mobile phone, and such a foldable-screen mobile phone may be referred to as a vertically foldable-screen mobile phone.

In the foldable-screen mobile phone, an electromagnetic wave signal emitted by an antenna 14 may be coupled to components in unstable contact in the rotary shaft assembly 11. When a coupling current of the antenna 14 passes through the components in unstable contact, a non-linear effect is generated in an unstable contact region between the components. FIG. 1A further shows an example of a possible structure of the rotary shaft assembly 11. As shown in FIG. 1A, the rotary shaft assembly 11 may include, for example, a shaft cover 111, a rotary shaft 112, a door panel 113, a cam 114, and a spring 115. The rotary shaft 112 is hinged in the shaft cover 111. A side of the door panel 113 is fixedly connected to or slidably connected to the rotary shaft 112, and the other side of the door panel 113 may be fixedly connected to or slidably connected to the body 12. The cam 114 abuts against one end of the rotary shaft 112 in an axial direction, and an abutting surface between the cam 114 and the rotary shaft 112 is a cam surface, which is used to provide damping when the body rotates. The spring 115 is in ground connection to one end that is of the cam 114 and that faces away from the rotary shaft 112, and is configured to apply a pressure required for abutting against the rotary shaft 112 to the cam 114.

In the foregoing structure of the rotary shaft assembly 11, there is unstable contact between the rotary shaft 112 and the cam 114, and there is unstable contact between the cam 114 and the spring 115. If the door panel 113 is slidably connected to the rotary shaft 112, there is unstable contact, and if the body 12 is slidably connected to the door panel 113, there is also unstable contact. Then, when the coupling current of the antenna 14 passes through the unstable contact region between the foregoing components, a non-linear effect is generated in the unstable contact region between the components.

The non-linear effect may cause harmonic waves, and a frequency of the harmonic waves is generally a multiple of a frequency of an original wave. A frequency of some harmonic waves is the same as or close to a frequency used for wireless communication of the electronic device, which may lead to exceeding radiated spurious emission (radiated spurious emission, RSE) of the entire electronic device. RSE is radiosensitivity of the electronic device to an electromagnetic field, and may be used to evaluate tolerance of the electronic device to an external electromagnetic field in a normal usage environment.

For example, a coupling current generated by an electromagnetic wave signal in a frequency band of 800 MHz generates a non-linear effect in an unstable contact region, which may generate a harmonic wave at 1600 MHz, a harmonic wave at 2500 MHz, a harmonic wave at 3200 MHz, and the like. Frequency bands of these harmonic waves are the same as or close to frequency bands of wireless networks such as a global system for mobile communications (global system for mobile communications, GSM), long term evolution (long term evolution, LTE), new radio (new radio, NR), Bluetooth, and wireless fidelity (wireless fidelity, Wi-Fi) that are used by the foldable-screen mobile phone. Consequently, wireless communication on these frequency bands is interfered with, thereby leading to exceeding RSE, and affecting communication performance of the foldable-screen mobile phone on these frequency bands.

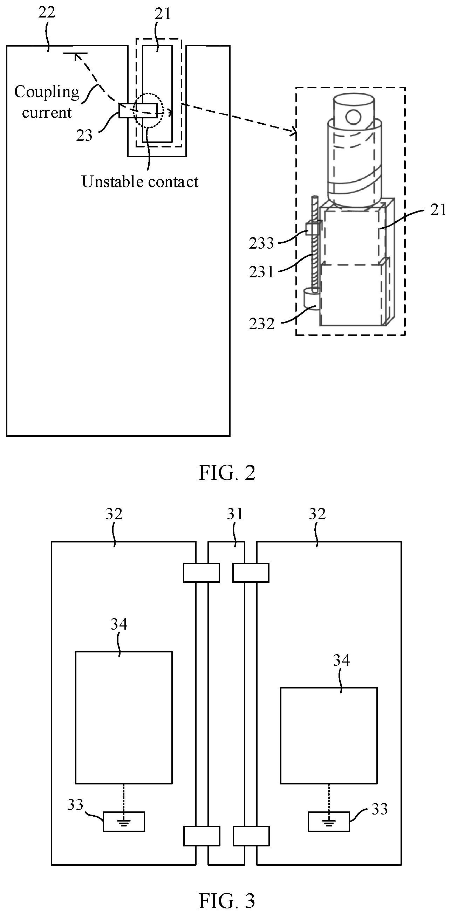

FIG. 2 is a scenario diagram of another non-linear effect according to an embodiment of this application.

Scenario 2: As shown in FIG. 2, some mobile phones each include a lifting assembly 21, for example, include a liftable camera module. The lifting assembly 21 may be connected to a middle frame 22 of the mobile phone through one or more drive structures 23, and the drive structure 23 may connect the lifting assembly 21 to the middle frame 22, and may drive the lifting assembly 21 to rise or fall. Generally, the drive structure 23 may include one or more components such as a screw 231, a motor 232, and a slider 233. One or more unstable contacts may be formed between components of the drive structure 23 and at junctions between some components and the middle frame 22 or the lifting assembly 21, thereby generating a non-linear effect. For example, the screw 231 may be connected to an output shaft of the motor 232. The slider 233 may be sleeved on the screw 231 to form a threaded connection to the screw 231. The lifting assembly 21 may be located on a side of the screw 231, and is fixedly connected to the slider 233. When the motor 232 drives the screw 231 to rotate, the slider 233 moves up and down with the rotation of the screw 231, thereby driving the lifting assembly 21 to rise and fall. The threaded connection between the screw 231 and the slider 233 forms unstable contact. Therefore, when the coupling current passes through an unstable contact region between the screw 231 and the slider 233, a non-linear effect is generated in the unstable contact region between the screw 231 and the slider 233, thereby generating harmonic waves, leading to exceeding RSE of the mobile phone, and affecting communication performance of the mobile phone.

FIG. 3 is a scenario diagram of still another non-linear effect according to an embodiment of this application.

Scenario 3: As shown in FIG. 3, the foldable-screen mobile phone generally includes a rotary shaft assembly 31 and two bodies 32 respectively disposed on two sides of the rotary shaft assembly. A metal region or a common ground cable may be provided in each body 32 as a reference ground 33 of the body. In addition, a battery 34 may be disposed in each body 32, so as to implement a larger battery capacity and prolong a battery life of the mobile phone. In this structure, negative electrodes of the two batteries 34 are generally coupled to the reference grounds 33 of the respective bodies 32. Therefore, to avoid a problem of unbalanced charging/discharging of the two batteries 34, impedance between the reference grounds 33 of the two bodies 32 needs to be as small as possible, so that potentials of the two reference grounds 33 are close to each other. However, due to non-linear contact in the rotary shaft assembly 31, impedance of the rotary shaft assembly 31 is increased, which leads to extremely large impedance between the reference grounds 33 of the two bodies 32, resulting in a problem of unbalanced charging/discharging of the two batteries 34.

In the foregoing scenarios, generation of harmonic waves, exceeding RSE of an entire electronic device, and unbalanced charging/discharging between two batteries of the electronic device that are caused by the non-linear effect are all electromagnetic compatibility problems of the electronic device.

An embodiment of this application provides an electromagnetic protection structure, to resolve an electromagnetic compatibility problem of the electronic device such as a mobile phone that is caused by a non-linear effect. The electromagnetic protection structure may be used in any electronic device that has or may have a non-linear effect, for example, a foldable-screen mobile phone, a mobile phone with a liftable camera module, a slider phone, a flip phone, a bar-type phone, a tablet computer, a personal computer, an intelligent wearable device, a vehicle-mounted device, a station STA device, a wireless access point AP device, an Internet of Things device, and a smart household device.

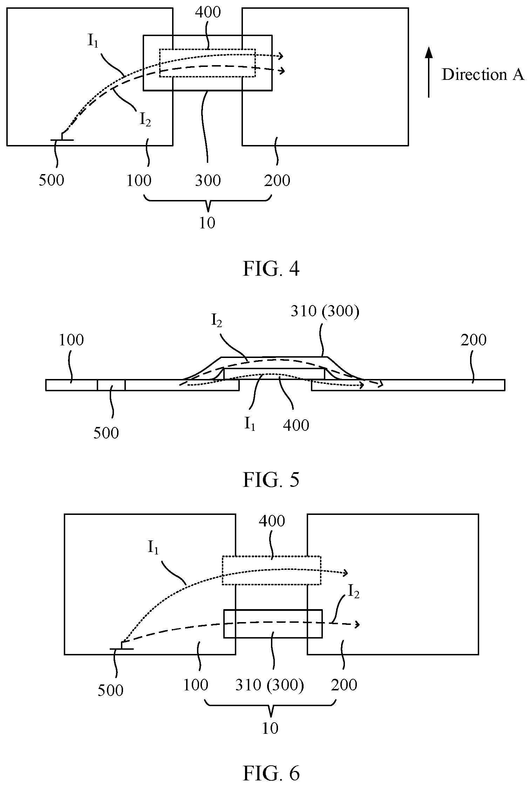

FIG. 4 is a schematic diagram of an electromagnetic protection structure 10 according to an example embodiment of this application.

As shown in FIG. 4, in an embodiment, the electromagnetic protection structure 10 may include:
a first structural member 100 and a second structural member 200, where a first current path I₁ is coupled between the first structural member 100 and the second structural member 200. The first structural member 100 and the second structural member 200 may be components that have a conductive capability. The first current path I₁ may include a non-linear region, where the non-linear region may include an unstable contact region between at least two components on the first current path I₁, and relative displacement may be generated between the at least two components forming the unstable contact region on the first current path I₁. When a coupling current of a radio frequency source (for example, an antenna) passes through the non-linear region, a non-linear effect is generated in the non-linear region.

Materials of the first structural member 100 and the second structural member 200 may be the same or different.

For example, the materials of the first structural member 100 and the second structural member 200 may include metal, for example, an alloy including aluminum, magnesium, steel, copper, and a plurality of types of metal.

For example, the materials of the first structural member 100 and the second structural member 200 may alternatively include non-metal having a conductive capability, for example, graphite, a conductive polymer, and conductive ceramic.

For example, in addition to including a material having a conductive capability, the first structural member 100 and the second structural member 200 may alternatively be components formed by a combination of a conductive material and a non-conductive material, for example, components formed by injection molding of metal and plastic.

Certainly, the first structural member 100 and the second structural member 200 may alternatively include another conductive material. This is not specifically limited herein.

In this embodiment of this application, the first structural member 100 and the second structural member 200 may further include a first connecting member 400 therebetween. The first connecting member 400 may be electrically connected to the first structural member 100 and the second structural member 200 separately to form the first current path I₁. In this way, a current in the first structural member 100 may flow to the second structural member 200 through the first connecting member 400, or a current in the second structural member 200 may flow to the first structural member 100 through the first connecting member 400.

For example, the first structural member 100 and the second structural member 200 may be respectively disposed on two sides of the first connecting member 400. One end of the first connecting member 400 may be connected to the first structural member 100, and the other end of the first connecting member 400 may be connected to the second structural member 200. In this way, the first structural member 100 and the second structural member 200 may be connected together by using the first connecting member 400 to form the first current path I₁.

In this embodiment of this application, the first structural member 100 and the first connecting member 400, and the second structural member 200 and the first connecting member 400 may be electrically connected in any connection manner, for example, welding, riveting, adhesion, screwing, hinging, pin connection, elastic connection, embedded connection, buckle connection, and slidable connection. A specific connection manner used by the first structural member 100 and the first connecting member 400, and by the second structural member 200 and the first connecting member 400 may be determined based on specific structures of the first structural member 100, the second structural member 200, and the first connecting member 400, and an actual product requirement. This is not limited in embodiments of this application.

In this embodiment of this application, the first connecting member 400 may be any component that has a connection, drive, or drive function. The first connecting member 400 may include at least one component, for example, a shaft member, a hole member, a hinge, a gear, a rack, a cam, a spring, a swing arm, a connecting rod, a slide rail, a guide rail, a threaded member, a pin member, a cable, and a chain. When the first connecting member 400 includes a plurality of components, different connection manners may be formed between the plurality of components, for example, welding, riveting, adhesion, screwing, hinging, pin connection, elastic connection, embedded connection, buckle connection, and slidable connection.

In this embodiment of this application, there may be a plurality of connection manners between the components in the first connecting member 400.

When there is a connection manner such as hinging, pin connection, or slidable connection between the components in the first connecting member 400, at least two components may form unstable contact. In other words, there is an unstable contact region between at least two components in the first connecting member 400.

In addition, there may also be a plurality of connection manners between the first structural member 100 and the first connecting member 400. When there is a connection manner such as hinging, pin connection, or slidable connection between the first structural member 100 and the first connecting member 400, unstable contact may be formed between the first structural member 100 and the first connecting member 400. In other words, there is an unstable contact region between the first structural member 100 and the first connecting member 400.

In addition, there may also be a plurality of connection manners between the second structural member 200 and the first connecting member 400. When there is a connection manner such as hinging, pin connection, or slidable connection between the second structural member 200 and the first connecting member 400, unstable contact may be formed between the second structural member 200 and the first connecting member 400. In other words, there is an unstable contact region between the second structural member 200 and the first connecting member 400.

It can be learned that there is a non-linear region on the first current path I₁. The non-linear region may include, for example, an unstable contact region between at least two components in the first connecting member 400, an unstable contact region between the first structural member 100 and the first connecting member 400, and/or an unstable contact region between the second structural member 200 and the first connecting member 400.

In this embodiment of this application, the first structural member 100 further includes a radio frequency source 500. The radio frequency source 500 may include, for example, an antenna in the first structural member 100, and may specifically include an antenna stub. The antenna may be generally disposed on an edge of the first structural member 100, so as to facilitate receiving a signal from the outside, or sending a signal to the outside. The antenna may be an antenna used for signals in one or more mobile networks such as global system for mobile communications GSM, long term evolution LTE, and new radio NR. The antenna may alternatively be an antenna configured to receive signals in wireless networks such as Wireless Fidelity Wi-Fi and Bluetooth. The antenna may alternatively be an antenna configured to receive another network signal such as a satellite signal. The antenna stub is a branch or a part of an antenna formed by a conductor, and is configured to change a radiation characteristic of the antenna or implement a specific function.

When the radio frequency source 500 receives or transmits a radio frequency signal, a coupling current is generated. The coupling current may include, for example, a ground current. The ground current may be a current generated between a radiation part of the antenna and the ground. When the antenna emits or receives an electromagnetic wave, the coupling current flows from the first structural member to another component.

In this embodiment of this application, the electromagnetic protection structure 10 further includes a conductive medium 300. The conductive medium 300 may be a component that has a conductive capability. The conductive medium 300 may have low impedance, and when a current passes through the conductive medium 300, a non-linear effect is not generated in the conductive medium 300.

The conductive medium 300 is electrically connected to the first structural member 100 and the second structural member 200 separately to form a second current path I₂ between the first structural member 100 and the second structural member 200. Impedance of the second current path I₂ is less than impedance of the first current path I₁.

The second current path I₂ may implement a shunting effect on the first current path I₁. In other words, if the electromagnetic protection structure 10 does not include the conductive medium 300, a coupling current in the first structural member 100 flows to the second structural member 200 through the first current path I₁. However, due to existence of the conductive medium 300, and because the impedance of the second current path I₁ formed by the conductive medium 300 is lower, at least a part of the coupling current flows to the second structural member 200 through the second current path I₂, thereby implementing a shunting effect of the second current path I₂ on the first current path I₁.

It may be understood that the coupling current on the first current path I₁ decreases because of the shunting effect of the second current path I₂ on the first current path I₁. Therefore, a non-linear effect on the first current path I₁ can be effectively reduced or even eliminated.

In this embodiment of this application, electrical connections between the first structural member 100 and the conductive medium 300, and between the second structural member 200 and the conductive medium 300 may be implemented in a stable contact connection manner. In this way, when the coupling current passes through the second current path I₂, a non-linear effect is not generated in a contact region between the first structural member 100 and the conductive medium 300 and a contact region between the second structural member 200 and the conductive medium 300, so that no harmonic wave is generated. In addition, the impedance of the second current path I₂ can be effectively reduced.

In this embodiment of this application, the conductive medium 300 may be any medium that has a conductive capability. The conductive medium 300 may be designed in a plurality of structural forms, for example, may be a sheet-shaped conductive medium, a fibrous conductive medium, a conducting cable, or a conductive adhesive.

The sheet-shaped conductive medium may be, for example, sheet-shaped metal, a conductive foam, or conductive mylar. The sheet-shaped metal includes but is not limited to a copper foil, an aluminum foil, a gold foil, a copper sheet, an aluminum sheet, and a steel sheet. The fibrous conductive medium may be, for example, a conductive fiber cloth or conductive fiber cotton. The conducting cable may be, for example, a coaxial cable, a multi-core cable, or a flat cable. Metal lugs may be disposed at two ends of the conducting cable, so that the conducting cable is in contact with the first structural member 100 and the second structural member 200 by using the metal lugs, thereby increasing a contact area and reducing contact impedance.

Implementations and application scenarios of the electromagnetic protection structure 10 in embodiments of this application are further described below by using an example in which the conductive medium 300 is a sheet-shaped conductive medium.

FIG. 5 is a view of the electromagnetic protection structure 10 provided in FIG. 4 in a direction A.

As shown in FIG. 4 and FIG. 5, in an implementation, a sheet-shaped conductive medium 310 may be located in a projection region of the first current path I₁. For example, the sheet-shaped conductive medium 310 may cover surfaces of the first structural member 100, the second structural member 200, and the first connecting member 400. For example, one end of the sheet-shaped conductive medium 310 may extend from the surface of the first connecting member 400 to the surface of the first structural member 100, and is attached to the surface of the first structural member 100 by using a conductive adhesive or the like, so as to implement an electrical connection between the sheet-shaped conductive medium 310 and the first structural member 100. In addition, the other end of the sheet-shaped conductive medium 310 may extend from the surface of the first connecting member 400 to the surface of the second structural member 200, and is attached to the surface of the second structural member 200 by using a conductive adhesive or the like, so as to implement an electrical connection between the sheet-shaped conductive medium 310 and the second structural member 200.

FIG. 6 is a schematic diagram of another electromagnetic protection structure 10 according to an example embodiment of this application.

As shown in FIG. 6, in an implementation, one end of the sheet-shaped conductive medium 310 is attached to the first structural member 100, and forms an electrical connection with the first structural member 100. The other end of the sheet-shaped conductive medium 310 is attached to the second structural member 200, and forms an electrical connection to the first structural member 100. In addition, the sheet-shaped conductive medium 310 is closer to edges of the first structural member 100 and the second structural member 200 than the first connecting member 400. In other words, a distance between the sheet-shaped conductive medium 310 and the edge of the first structural member 100 is less than a distance between the first connecting member 400 and the edge of the first structural member 100. In such a structure, a length of the second current path I₂ is shorter than a length of the first current path I₁, and impedance is also lower, which helps improve a shunting effect of the second current path I₂.

In an implementation, a width of the sheet-shaped conductive medium 310 may be greater than 0.5 millimeter, preferably greater than 1 millimeter, and a thickness of the sheet-shaped medium may be less than 4 millimeters, preferably less than 2 millimeters. In this way, the sheet-shaped conductive medium 310 can have low impedance. A length of the sheet-shaped conductive medium 310 may be selected based on an actual requirement. This is not specifically limited herein.

In an implementation, each of a contact area between the sheet-shaped conductive medium 310 and the first structural member 100 and a contact area between the sheet-shaped conductive medium 310 and the second structural member 200 is greater than 2 square millimeters. In this way, there may be low contact impedance between the sheet-shaped conductive medium 310 and the first structural member 100 and between the sheet-shaped conductive medium 310 and the second structural member 200.

It can be learned from the foregoing technical solutions that, in the electromagnetic protection structure 10 provided in this embodiment of this application, when there is a non-linear region on the first current path I₁ between the first structural member 100 and the second structural member 200, the second current path I₂ is added between the first structural member 100 and the second structural member 200 by using the conductive medium 300. The second current path I₂ has lower impedance, and does not generate a non-linear effect. Therefore, the first current path I₁ can be shunted, so as to eliminate or weaken a non-linear effect on the first current path I₁. Therefore, when the electromagnetic protection structure 10 provided in this embodiment of this application is used in an electronic device, an electromagnetic compatibility problem of the electronic device caused by the non-linear effect can be resolved.

In some embodiments, the electromagnetic protection structure 10 may be used in an electronic device including a rotating component, for example, may be used in a foldable-screen mobile phone.

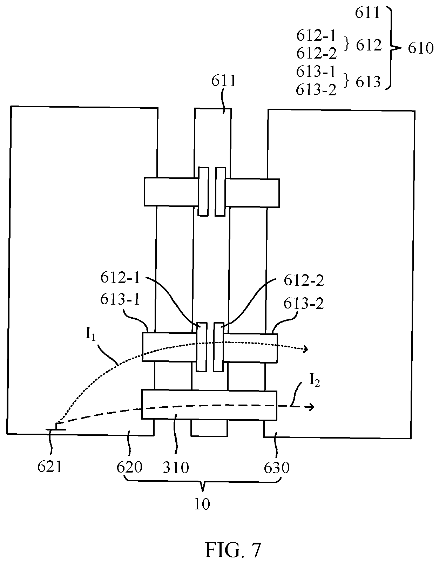

FIG. 7 is a first schematic application diagram of an electromagnetic protection structure 10 according to an example embodiment of this application.

As shown in FIG. 7, the foldable-screen mobile phone may include:
a rotary shaft assembly 610, and a first middle frame 620 and a second middle frame 630 that are respectively disposed on two sides of the rotary shaft assembly 610.

The first middle frame 620, the second middle frame 630, and the rotary shaft assembly 610 are generally of conductive metal structures to ensure connection strength.

The first middle frame 620 serves as a support structure of the foldable-screen mobile phone, and may carry various modules in the electronic device, for example, a camera module, a battery, an antenna, a circuit board, various sensors, a motor, and a key. Similarly, the second middle frame 630 serves as a support structure of the foldable-screen mobile phone, and may also carry various modules in the electronic device. Generally, a type and a quantity of modules carried by the first middle frame 620 may be different from those of modules carried by the second middle frame 630.

A function of the rotary shaft assembly 610 is to form a rotatable connection to the first middle frame 620 and the second middle frame 630 separately. To implement this function, as shown in FIG. 7, the rotary shaft assembly 610 may include, for example, a rotary shaft body 611, a rotating structure 612, and a connecting structure 613. The rotary shaft body 611 may include a shaft cover, and is a basic part of the rotary shaft assembly 610. The rotating structure 612 may be disposed on the rotary shaft body 611, and generally may include components used to implement a rotation function, such as a gear and a camspring. There may be unstable contact between these components. The connecting structure 613 may include components such as a swing arm and a connecting rod. One end of the connecting structure 613 may be rotatably connected to the rotating structure 612 to form unstable contact. The other end of the connecting structure 613 may be fixedly connected to the first middle frame 620 or the second middle frame 630, so that the connecting structure 613 is in stable contact with the first middle frame 620 or the second middle frame 630. In this way, the first middle frame 620 may rotate around the rotary shaft body 611, so that the foldable-screen mobile phone is unfolded or folded.

The rotary shaft body 611 may be connected to each middle frame of the foldable-screen mobile phone by using at least one group of rotating structure 612 and connecting structure 613. For example, a rotating structure 612-1 and a connecting structure 613-1 cooperate with each other as one group to connect the rotary shaft body 611 to the first middle frame 620. For another example, a rotating structure 612-2 and a connecting structure 613-2 cooperate with each other as one group to connect the rotary shaft body 611 to the second middle frame 630.

In the foldable-screen mobile phone shown in FIG. 7, there is unstable contact between components of the rotating structure 612 and at a junction between the rotating structure 612 and the connecting structure 613. Therefore, there is a non-linear region in the rotary shaft assembly 610. The non-linear region may include, for example, an unstable contact region between at least two components in the rotating structure 612, and\or an unstable contact region between the rotating structure 612 and the connecting structure 613. In other words, the non-linear region includes an unstable contact region between at least two components in the rotary shaft assembly 610.

Therefore, when a coupling current flows from the first middle frame 620 to the second middle frame 630 through the rotary shaft assembly 610, or when a coupling current flows from the second middle frame 630 to the first middle frame 620 through the rotary shaft assembly 610, a non-linear effect may be generated in the non-linear region in the rotary shaft assembly 610, resulting in an electromagnetic compatibility problem.

The coupling current in the first middle frame 620 may be a ground current generated when an antenna of the foldable-screen mobile phone receives or transmits an electromagnetic wave. In the foldable-screen mobile phone, the antenna is generally disposed on an outer edge of the entire mobile phone, for example, is disposed on an outer edge of the first middle frame 620. Generally, the outer edge of the first middle frame 620 may include one or more antennas. Some antennas, for example, a first antenna 621, are close to the rotary shaft assembly 610. Therefore, a coupling current near the first antenna 621 may flow from the first middle frame 620 to the second middle frame 630 through the connecting structure 613-1, the rotating structure 612-1, the rotary shaft body 611, the rotating structure 612-2, and the connecting structure 613-2 in the rotary shaft assembly 610 sequentially. Consequently, a non-linear effect is generated in the non-linear region through which the coupling current passes, resulting in an electromagnetic compatibility problem. A current path formed by the connecting structure 613-1, the rotating structure 612-1, the rotary shaft body 611, the rotating structure 612-2, and the connecting structure 613-2 serves as the first current path I₁.

To resolve an electromagnetic compatibility problem caused by the non-linear effect, the first middle frame 620 and the second middle frame 630 may be electrically connected by using the sheet-shaped conductive medium 310, for example, sheet-shaped metal, so as to shunt a coupling current in the first current path I₁.

In an implementation, one end of the sheet-shaped conductive medium 310 may be attached to the first middle frame 620, so that an electrical connection and stable contact are formed between the sheet-shaped conductive medium 310 and the first middle frame 620. In addition, the other end of the sheet-shaped conductive medium 310 is attached to the second middle frame 630, so that an electrical connection and stable contact are formed between the sheet-shaped conductive medium 310 and the second middle frame 630. In this way, the first middle frame 620 serves as the first structural member 100, the second middle frame 630 serves as the second structural member 200, the connecting structure 613-1, the rotating structure 612-1, the rotary shaft body 611, the rotating structure 612-2, and the connecting structure 613-2 in the rotary shaft assembly 610 serve as the first connecting member 400, and the sheet-shaped conductive medium 310 may form the second current path I₂ between the first middle frame 620 and the second middle frame 630.

In this implementation, the second current path I₂ formed by the sheet-shaped conductive medium 310 may shunt the first current path I₁, so as to eliminate or weaken a non-linear effect of a non-linear region on the first current path I₁. Therefore, in this implementation, an electromagnetic compatibility problem of the foldable-screen mobile phone caused by the non-linear effect can be resolved.

The ground current of the antenna is mainly distributed on an outer edge of the middle frame of the electronic device due to impact of a structure characteristic that the antenna is located on the outer edge of the entire mobile phone and a boundary condition of the electromagnetic wave, and few ground currents are distributed inside the middle frame. The boundary condition of the electromagnetic wave refers to a condition that needs to be met on an interface by an electromagnetic wave propagating between two different media, including continuity of a normal component, continuity of a normal/tangential component, and the like. The boundary condition of the electromagnetic wave is conventional knowledge in the art, and is not elaborated herein.

Further, as shown in FIG. 7, based on a distribution characteristic of the ground current, in an implementation, the sheet-shaped conductive medium 310 may be closer to the first antenna 621 than the connecting structure 613 and the rotating structure 612. In other words, the sheet-shaped conductive medium 310 may be closer to the outer edge of the first middle frame 620 than the connecting structure 613 and the rotating structure 612. In this way, the second current path I₂ may be established in a region in which more ground currents are distributed, so as to shunt away more ground currents. In addition, a length of the second current path I₂ may be shortened, so that the length of the second current path I₂ is shorter than a length of the first current path I₁, and impedance of the second current path I₂ is reduced, thereby improving a shunting effect of the second current path I₂ on the first current path I₁.

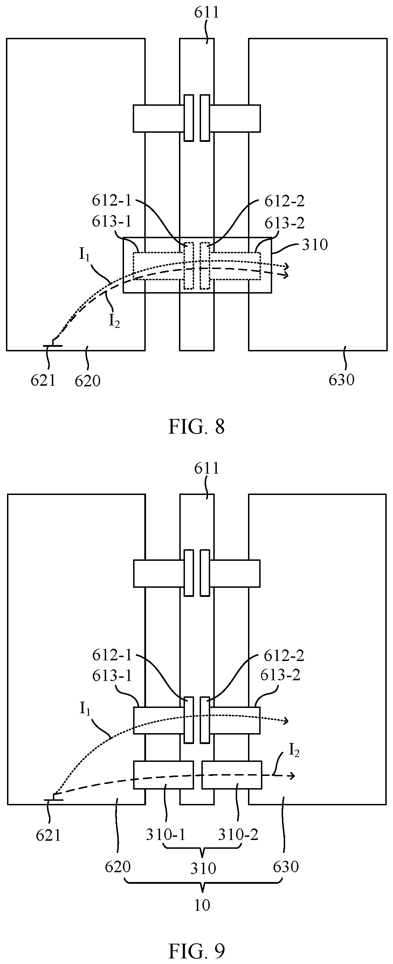

FIG. 8 is a second schematic application diagram of an electromagnetic protection structure 10 according to an example embodiment of this application.

As shown in FIG. 8, in an implementation, the sheet-shaped conductive medium 310 may cover a surface of at least one component on the first current path I₁. For example, the sheet-shaped conductive medium 310 may cover a surface of at least one component in the connecting structure 613-1, the rotating structure 612-1, the rotary shaft body 611, the rotating structure 612-2, and the connecting structure 613-2. In this way, in addition to forming electrical connections to the first middle frame 620 and the second middle frame 630, the sheet-shaped conductive medium 310 can further form electrical connections to components in the first current path I₁. Therefore, when the coupling current passes through the components in the first current path I₁, the sheet-shaped conductive medium 310 may further shunt away the coupling current from these components, so as to improve a shunting effect of the second current path I₂ on the first current path I₁.

FIG. 9 is a third schematic application diagram of an electromagnetic protection structure 10 according to an example embodiment of this application.

As shown in FIG. 9, in an implementation, the sheet-shaped conductive medium 310 may not shunt the entire first current path I₁, but shunt only a part of the first current path I₁. For example, only a section from the first middle frame 620 to the rotary shaft body 611 of the first current path I₁ is shunted, or only a section from the rotary shaft body 611 to the second middle frame 630 of the first current path I₁ is shunted. In addition, two or more sheet-shaped conductive media 310 may be disposed, and the first current path I₁ is shunted in sections by using the plurality of sheet-shaped conductive media 310.

For example, one end of a sheet-shaped conductive medium 310-1 may be attached to the first middle frame 620, so that an electrical connection and stable contact are formed between the sheet-shaped conductive medium 310 and the first middle frame 620. The other end of the sheet-shaped conductive medium 310 spans across the connecting structure 613-1 and the rotating structure 612-1, and is attached to the rotary shaft body 611, so that stable contact is formed between the sheet-shaped conductive medium 310 and the rotary shaft body 611. In this way, the sheet-shaped conductive medium 310 may form the second current path I₂ between the first middle frame 620 and the rotary shaft body 611, so as to shunt the section between the first middle frame 620 and the rotary shaft body 611 of the first current path I₁. In this example, the first middle frame 620 serves as the first structural member 100, the rotary shaft body 611 serves as the second structural member 200, and the connecting structure 613-1 and the rotating structure 612-1 serve as the first connecting member 400.

Alternatively, one end of a sheet-shaped conductive medium 310-2 may be attached to the second middle frame 630, so that an electrical connection and stable contact are formed between the sheet-shaped conductive medium 310 and the second middle frame 630. The other end of the sheet-shaped conductive medium 310 spans across the connecting structure 613-2 and the rotating structure 612-2, and is attached to the rotary shaft body 611, so that stable contact is formed between the sheet-shaped conductive medium 310 and the rotary shaft body 611. In this way, the sheet-shaped conductive medium 310 may form the second current path I₂ between the second middle frame 630 and the rotary shaft body 611, so as to shunt the section between the rotary shaft body 611 and the second middle frame 630 of the first current path I₁. In this example, the rotary shaft body 611 serves as the first structural member 100, the second middle frame 630 serves as the second structural member 200, and the connecting structure 613-2 and the rotating structure 612-2 serve as the first connecting member 400.

In addition, the section between the first middle frame 620 and the rotary shaft body 611 and the section between the rotary shaft body 611 and the second middle frame 630 of the first current path I₁ may be respectively shunted by using both the sheet-shaped conductive medium 310-1 and the sheet-shaped conductive medium 310-2.

It should be further noted that, in this implementation, the manner shown based on FIG. 9 of performing partial or sectioned shunting on the first current path I₁ by using the sheet-shaped conductive medium 310-1 and/or the sheet-shaped conductive medium 310-2 is merely a partial implementation, not all implementations. In another implementation, two ends of the sheet-shaped conductive medium 310 may be attached to any two positions on the first current path I₁, provided that the sheet-shaped conductive medium 310 can take a partial shunting effect on the first current path I₁, and it is not beyond the protection scope of embodiments of this application.

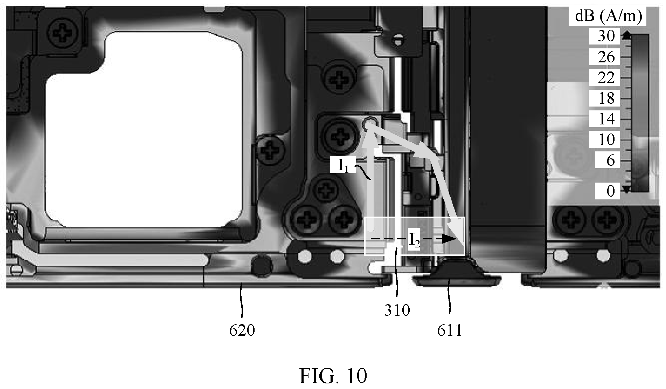

FIG. 10 is an electromagnetic simulation diagram of an entire foldable-screen mobile phone according to an example embodiment of this application.

As shown in FIG. 10, in some implementations, an attaching position of the sheet-shaped conductive medium 310 may alternatively be determined based on an electromagnetic simulation result of the entire foldable-screen mobile phone. For example, the distribution characteristic of the coupling current of the first antenna 621 in the foldable-screen mobile phone may be simulated to obtain the distribution characteristic of the coupling current of the first antenna 621 in the foldable-screen mobile phone. For example, in FIG. 10, a gain (in a unit of dBA) of a ground current is represented as a color shade in the figure, a lighter color indicates a larger current gain, and a darker color indicates a smaller current gain. Next, based on the distribution characteristic of the coupling current in the foldable-screen mobile phone, a coupling path of the coupling current between the first middle frame 620 and the rotary shaft body 611 may be found, that is, the first current path I₁. Further, a shortest path of the coupling current between the first middle frame 620 and the rotary shaft body 611 may be determined based on the coupling path of the coupling current between the first middle frame 620 and the rotary shaft body 611, and the sheet-shaped conductive medium 310 is added to the shortest path, so as to form the second current path I₂ on the shortest path by using the sheet-shaped conductive medium 310.

After the shortest path of the coupling current between the first middle frame 620 and the rotary shaft body 611 is determined, and the sheet-shaped conductive medium 310 is added to the shortest path, simulation analysis may be further performed on a coupling current gain of a problem point in the non-linear region between the first middle frame 620 and the rotary shaft body 611, so as to check a shunting effect achieved by the sheet-shaped conductive medium 310.

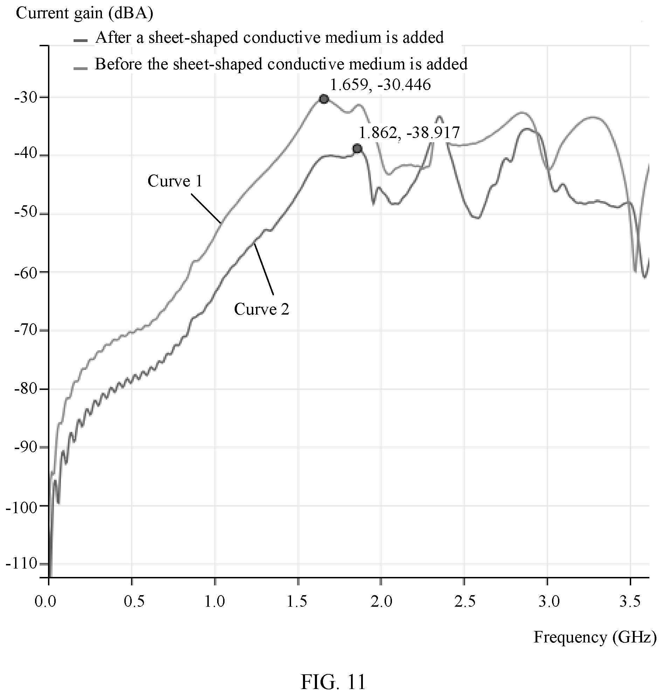

FIG. 11 is a schematic diagram of a shunting effect of a sheet-shaped conductive medium according to an example embodiment of this application.

In FIG. 11, an x axis represents a frequency (in a unit of GHz) of an electromagnetic wave, a y axis represents a current gain (in a unit of dBA), a curve 1 represents a coupling current gain of a problem point before the sheet-shaped conductive medium 310 is added, and a curve 2 represents a coupling current gain of the problem point after the sheet-shaped conductive medium 310 is added. It can be learned that after the sheet-shaped conductive medium 310 is added, the coupling current gain of the problem point is reduced by 8 dBA~9 dBA compared with the coupling current gain of the problem point before the sheet-shaped conductive medium 310 is added. For example, when the electromagnetic wave is near 1.700 GHz, before the sheet-shaped conductive medium 310 is added, the coupling current gain is -30.446 dBA, and after the sheet-shaped conductive medium 310 is added, the coupling current gain is -39.917 dBA. It can be learned that in this embodiment of this application, the sheet-shaped conductive medium 310 may have a significant shunting effect on the first current path I₁.

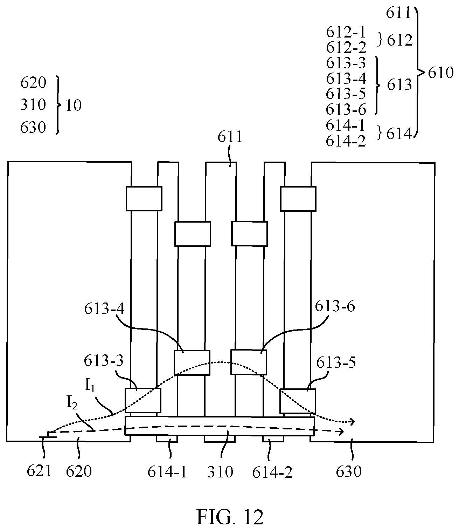

FIG. 12 is a fourth schematic application diagram of an electromagnetic protection structure 10 according to an example embodiment of this application.

As shown in FIG. 12, the rotary shaft assembly 610 of some foldable-screen mobile phones may have a more complex structure. For example, in addition to the rotary shaft body 611, the rotary shaft assembly 610 further includes a door panel 614 between each middle frame and the rotary shaft body 611, and each door panel 614 may be connected to the middle frame and rotary shaft body 611 that are adjacent to door panel 614 by using the connecting structure 613. For example, a door panel 614-1 may be connected to the first middle frame 620 and the rotary shaft body 611 by using a connecting structure 613-3 and a connecting structure 613-4, and a door panel 614-2 may be connected to the second middle frame 630 and the rotary shaft body 611 by using a connecting structure 613-5 and a connecting structure 613-6. That the door panel 614-1 is connected to the first middle frame 620 and the rotary shaft body 611 by using the connecting structure 613 is used as an example below to describe connection manners between the door panel 614 and the middle frame and between the door panel 614 and the rotary shaft body 611.

For example, the connecting structure 613-3 may be disposed between the first middle frame 620 and the door panel 614-1. One end of the connecting structure 613-3 may be fixedly connected to the first middle frame 620 to form stable contact, and the other end of the connecting structure 613-3 may be slidably connected to the door panel 614 to form unstable contact. In addition, the connecting structure 613-4 may be disposed between the door panel 614 and the rotary shaft body 611. One end of the connecting structure 613-4 may be slidably connected to the door panel 614 to form unstable contact, and the other end of the connecting structure 613-4 may be fixedly connected to the rotary shaft body 611 to form stable contact.

It should be noted that, in the foregoing example, a connection manner between the door panel 614, the connecting structure 613-3, the connecting structure 613-4, the first middle frame 620, and the rotary shaft body 611 is merely used as an example. In a specific implementation of the foldable-screen mobile phone, there may be another connection manner between the components. For example, the connecting structure 613-3 may be slidably connected to the first middle frame 620, the connecting structure 613-3 may be fixedly connected to the door panel 614, and the connecting structure 613-4 may be slidably connected to the rotary shaft body 611. In other words, when the rotary shaft assembly 610 of the foldable-screen mobile phone includes the door panel 614, the unstable contact may alternatively be located at a position other than the foregoing example.

It can be learned that in a structure in which the rotary shaft assembly 610 includes the door panel 614, the rotary shaft body 611, the door panels 614 on the two sides of the rotary shaft body 611, and the connecting structure 613 jointly form the first current path I₁ between the first middle frame 620 and the second middle frame 630. In addition, there is a non-linear region in the first current path I₁. The non-linear region may include, for example, an unstable contact region between the connecting structure 613-3 and the door panel 614, and/or an unstable contact region between the connecting structure 613-4 and the door panel 614. Further, as shown in FIG. 12, in an implementation, to resolve a non-linear problem, one end of the sheet-shaped conductive medium 310 may be attached to the first middle frame 620, so that an electrical connection and stable contact are formed between the sheet-shaped conductive medium 310 and the first middle frame 620. The other end of the sheet-shaped conductive medium 310 is attached to the second middle frame 630, so that an electrical connection and stable contact are formed between the sheet-shaped conductive medium 310 and the second middle frame 630. In this way, the sheet-shaped conductive medium 310 may form the second current path I₂ between the first middle frame 620 and the second middle frame 630. In this implementation, the first middle frame 620 serves as the first structural member 100, the second middle frame 630 serves as the second structural member 200, the rotary shaft body 611, the door panels 614 on the two sides of the rotary shaft body 611, and the connecting structure 613 that are in the rotary shaft assembly 610 serve as the first connecting member 400.

In this implementation, the second current path I₂ formed by the sheet-shaped conductive medium 310 may shunt the first current path I₁, so as to eliminate or weaken a non-linear effect of a non-linear region on the first current path I₁. Therefore, in this implementation, an electromagnetic compatibility problem of the foldable-screen mobile phone caused by the non-linear effect can be resolved.

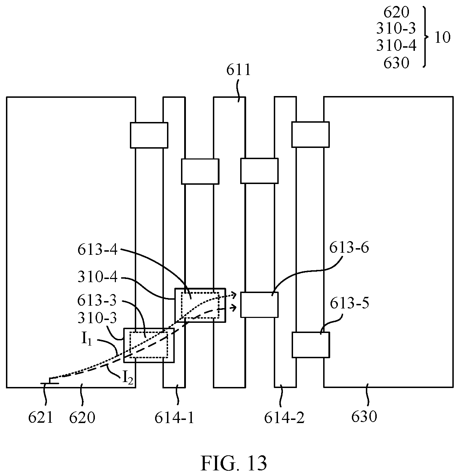

FIG. 13 is a fifth schematic application diagram of an electromagnetic protection structure 10 according to an example embodiment of this application.

As shown in FIG. 13, in an implementation, the first current path I₁ may be partially shunted by using the sheet-shaped conductive medium 310.

For example, one end of a sheet-shaped conductive medium 310-3 may be attached to the first middle frame 620, so that an electrical connection and stable contact are formed between the sheet-shaped conductive medium 310-3 and the first middle frame 620. The other end of the sheet-shaped conductive medium 310-3 spans across the connecting structure 613-3, and is attached to the door panel 614-1, so that stable contact is formed between the sheet-shaped conductive medium 310-3 and the door panel 614-1. In this way, the sheet-shaped conductive medium 310 may form the second current path I₂ between the first middle frame 620 and the door panel 614-1, so as to shunt a section between the first middle frame 620 and the door panel 614-1 of the first current path I₁. In this example, the first middle frame 620 serves as the first structural member 100, the door panel 614-1 serves as the second structural member 200, and the connecting structure 613-3 serves as the first connecting member 400.

Alternatively, one end of the sheet-shaped conductive medium 310-4 may be attached to the door panel 614-1, so that an electrical connection and stable contact are formed between the sheet-shaped conductive medium 310-4 and the door panel 614-1. The other end of the sheet-shaped conductive medium 310-4 spans across the connecting structure 613-4, and is attached to the rotary shaft body 611, so that stable contact is formed between the sheet-shaped conductive medium 310-4 and the rotary shaft body 611. In this way, the sheet-shaped conductive medium 310-4 may form the second current path I₂ between the door panel 614-1 and the rotary shaft body 611, so as to shunt a section between the door panel 614-1 and the rotary shaft body 611 of the first current path I₁. In this example, the door panel 614-1 serves as the first structural member 100, the rotary shaft body 611 serves as the second structural member 200, and the connecting structure 613-4 serves as the first connecting member 400.

In addition, a section between the first middle frame 620 and the door panel 614 and a section between the door panel 614 and the rotary shaft body 611 of the first current path I₁ may be further respectively shunted by using both the sheet-shaped conductive medium 310-3 and the sheet-shaped conductive medium 310-4.

It may be understood that a shunting manner of a section between the rotary shaft body 611 and the door panel 614-2 and a section between the door panel 614-2 and the second middle frame 630 of the first current path I₁ is similar to the foregoing shunting manner shown in FIG. 13. Details are not described herein again.

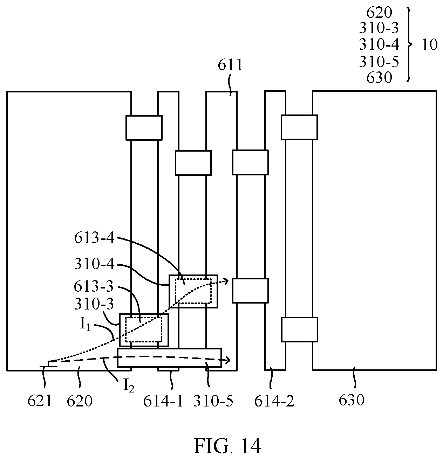

FIG. 14 is a sixth schematic application diagram of an electromagnetic protection structure 10 according to an example embodiment of this application.

As shown in FIG. 14, for example, one end of the sheet-shaped conductive medium 310-5 may be attached to the first middle frame 620, so that an electrical connection and stable contact are formed between the sheet-shaped conductive medium 310-5 and the first middle frame 620. The other end of the sheet-shaped conductive medium 310-5 sequentially spans across the connecting structure 613-3, the door panel 614-1, and the connecting structure 613-4, and is attached to the rotary shaft body 611, so that stable contact is formed between the sheet-shaped conductive medium 310-5 and the rotary shaft body 611. In this way, the sheet-shaped conductive medium 310-5 may form the second current path I₂ between the first middle frame 620 and the rotary shaft body 611, so as to shunt a section between the first middle frame 620 and the rotary shaft body 611 of the first current path I₁. In this example, the first middle frame 620 serves as the first structural member 100, the second middle frame 630 serves as the second structural member 200, and the connecting structure 613-3, the door panel 614-1, and the connecting structure 613-4 serve as the first connecting member 400.

It may be understood that a shunt manner of a section between the rotary shaft body 611 and the second middle frame 630 of the first current path I₁ is similar to the foregoing shunt manner shown in FIG. 14. Details are not described herein again.

It may be understood that the foregoing implementations shown in FIG. 13 and FIG. 14 are merely some implementations of performing partial shunting on the first current path I₁ by using the sheet-shaped conductive medium 310, but not all the implementations. For example, the foregoing implementations may be split or combined to obtain another implementation, or more or fewer sheet-shaped conductive media 310 may be disposed based on an actual structure of the rotary shaft assembly 610. These are not beyond the protection scope of this embodiment of this application.

In the implementations shown in FIG. 13 and FIG. 14, the second current path I₂ formed by the sheet-shaped conductive medium 310 may partially shunt the first current path I₁, so as to eliminate or weaken a non-linear effect of a non-linear region on the first current path I₁, thereby resolving an electromagnetic compatibility problem of the foldable-screen mobile phone caused by the non-linear effect.

In addition, it should be further noted that, in the foldable-screen mobile phone, the foldable screen is generally located on a side of the first middle frame 620, the rotary shaft assembly 610, and the second middle frame 630, and a side that is of the first middle frame 620, the rotary shaft assembly 610, and the second middle frame 630 and that faces away from the foldable screen is generally a housing of the foldable-screen mobile phone. In this embodiment of this application, the sheet-shaped conductive medium 310, for example, the sheet-shaped conductive medium 310, may be located on a side that is of the first middle frame 620, the rotary shaft assembly 610, and the second middle frame 630 and that faces a display, or may be located on the side that is of the first middle frame 620, the rotary shaft assembly 610, and the second middle frame 630 and that faces away from the foldable screen. Certainly, the sheet-shaped conductive medium 310 may alternatively be located on both sides of the first middle frame 620, the rotary shaft assembly 610, and the second middle frame 630. This is not specifically limited in embodiments of this application.

Generally, regardless of the inward foldable-screen mobile phone or the outward foldable-screen mobile phone, the foldable screen needs to have good strength and stability, so as to ensure that the foldable screen is not deformed or damaged in different states. To achieve this objective, the foldable screen generally includes a support structure, for example, a support plate. The support plate is generally made of a metal material with good strength and bending performance, for example, stainless steel. The support plate is generally attached to a back surface of a display panel of the foldable screen, and faces the first middle frame 620, the rotary shaft assembly 610, and the second middle frame 630.

Because the support plate is generally made of a metal material, and has conductivity, the support plate may serve as the conductive medium 300. In other words, the support plate may be electrically connected to the first middle frame 620 and the second middle frame 630, and the second current path I₂ is provided by using conductivity of the support plate, so as to shunt the first current path I₁.

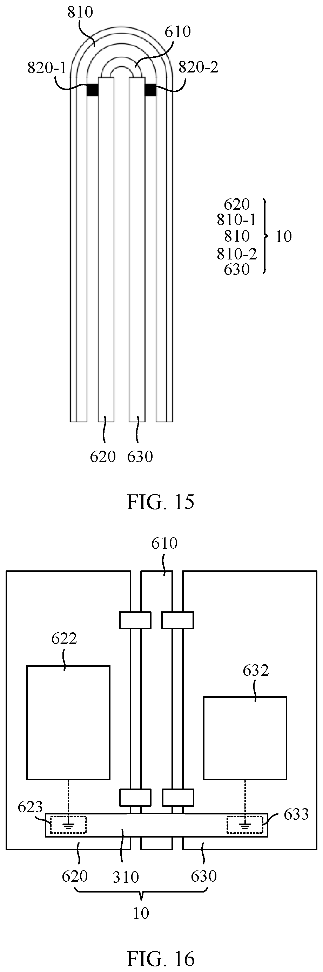

FIG. 15 is a seventh schematic application diagram of an electromagnetic protection structure 10 according to an example embodiment of this application.

Based on FIG. 15, the following uses the inward foldable-screen mobile phone as an example to describe a solution of providing the second current path I₂ by using conductivity of the support plate.

As shown in FIG. 15, a conductive filler 820-1 may be filled in a gap between the first middle frame 620 and a support plate 810. One end of the conductive filler 820-1 is electrically connected to the first middle frame 620, and the other end of the conductive filler 820-1 is electrically connected to the support plate 810, so as to implement an electrical connection between the first middle frame 620 and the support plate 810, so that a coupling current can flow from the first middle frame 620 to the support plate 810. In addition, a conductive filler 820-2 may be further filled in a gap between the second middle frame 630 and the support plate 810. One end of the conductive filler 820-2 is electrically connected to the second middle frame 630, and the other end of the conductive filler 820-2 is electrically connected to the support plate 810, so as to implement an electrical connection between the second middle frame 630 and the support plate 810, so that a coupling current can flow from the support plate 810 to the second middle frame 630. In this way, the conductive filler 820-1, the support plate 810, and the conductive filler 820-2 constitute the second current path I₂ between the first middle frame 620 and the second middle frame 630, so that a coupling current in the first middle frame 620 can flow to the second middle frame 630 through the conductive filler 820-1, the support plate 810, and the conductive filler 820-2, and the first current path I₁ is shunted, thereby eliminating or weakening a non-linear effect of the non-linear region on the first current path I₁, and resolving an electromagnetic compatibility problem of the foldable-screen mobile phone caused by the non-linear effect.

For example, the conductive filler 820-1 and the conductive filler 820-2 may be conductive foams. One end of one conductive foam may be adhered to the first middle frame 620, and the other end of the conductive foam may be adhered to the support plate 810, so as to implement the electrical connection between the first middle frame 620 and the support plate 810. In addition, one end of the other conductive foam is adhered to the second middle frame 630, and the other end of the other conductive foam is adhered to the support plate 810, so as to implement the electrical connection between the second middle frame 630 and the support plate 810.

In addition, the conductive filler 820-1 and the conductive filler 820-2 may alternatively use another material or structure that has a conductive capability, for example, a conductive elastic piece. Details are not described herein again.

FIG. 16 is an eighth schematic application diagram of an electromagnetic protection structure 10 according to an example embodiment of this application.

As shown in FIG. 16, compared with a conventional mobile phone, the foldable-screen mobile phone generally includes two or more batteries, and these batteries are distributed on the two sides of the rotary shaft assembly 610 and are electrically connected to reference grounds on the sides on which the batteries are located. The reference ground is a reference ground point of various circuits in the mobile phone, and is used to ensure operating stability of various circuits, and provide a stable ground reference for various electrical signals in the mobile phone. Generally, the battery, a middle frame, and various functional modules in a circuit in the mobile phone are coupled to the reference ground.

For example, the foldable-screen mobile phone shown in FIG. 16 includes two batteries. For ease of description, the two batteries are referred to as a first battery 622 and a second battery 632 herein. The first battery 622 is located on a side of the rotary shaft assembly 610, and is disposed on the first middle frame 620. A negative electrode of the first battery 622 may be coupled to a first reference ground on the first middle frame 620. The second battery 632 is located on the other side of the rotary shaft assembly 610, and is disposed on the second middle frame 630. A negative electrode of the second battery 632 may be coupled to a second reference ground on the second middle frame 630.

For example, the first reference ground may be, for example, first grounded metal 623 disposed on a circuit board of the first middle frame 620 or a dedicated ground cable. In this way, the negative electrode of the first battery 622 may be electrically connected to the first grounded metal 623, so as to implement grounding. The second reference ground may be, for example, second grounded metal 633 disposed on a circuit board of the second middle frame 630 or a dedicated ground cable. In this way, the negative electrode of the second battery 632 may be electrically connected to the second grounded metal 633, so as to implement grounding.

Because there is non-linear contact in the rotary shaft assembly 610, impedance of the rotary shaft assembly 610 is large, and consequently, impedance between the first grounded metal 623 and the second grounded metal 633 is also large. In this case, there may be a large potential difference between the first grounded metal 623 and the second grounded metal 633, which causes unbalanced charging/discharging of the first battery 622 and the second battery 632. For example, if a potential of the first grounded metal 623 is lower than a potential of the second grounded metal 633, in a discharge phase, the first battery 622 is discharged faster and more sufficiently, and the second battery 632 is discharged slower and may not be sufficiently discharged, and vice versa. In addition, if a potential of the first grounded metal 623 is lower than a potential of the second grounded metal 633, in a charge phase, the first battery 622 is charged faster and more sufficiently, and the second battery 632 is charged slower and may not be sufficiently charged, and vice versa.

As shown in FIG. 16, in some embodiments, the first grounded metal 623 and the second grounded metal 633 may be electrically connected by using the sheet-shaped conductive medium 310. In this way, the sheet-shaped conductive medium 310 may form a second current path I₂ between the first grounded metal 623 and the second grounded metal 633, and impedance of the second current path I₂ is lower, thereby reducing impedance between the first grounded metal 623 and the second grounded metal 633, and resolving a problem of unbalanced charging/discharging of the first battery 622 and the second battery 632. In this embodiment, the first middle frame 620 that includes the first grounded metal 623 serves as the first structural member 100, the second middle frame 630 that includes the second grounded metal 633 serves as the second structural member 200, and the rotary shaft assembly 610 serves as the first connecting member 400.

For example, one end of the sheet-shaped conductive medium 310 may be attached to a surface of the first grounded metal 623 by using a thermal conductive adhesive, to form stable contact. The other end of the sheet-shaped conductive medium 310 may span across the rotary shaft assembly 610, and be attached to the surface of the second grounded metal 633 by using a thermal conductive adhesive, to form stable contact. In this way, the sheet-shaped conductive medium 310 may form the second current path I₂ between the first grounded metal 623 and the second grounded metal 633.

In an implementation, a contact area between the sheet-shaped conductive medium 310 and the grounded metal may be increased to provide lower impedance. For example, the contact area between the sheet-shaped conductive medium 310 and the first grounded metal 623 may be greater than 2 square millimeters, preferably greater than 4 square millimeters, so as to ensure that the impedance between the sheet-shaped conductive medium 310 and the first grounded metal 623 is sufficiently small. In addition, the contact area between the sheet-shaped conductive medium 310 and the second grounded metal 633 may also be greater than 2 square millimeters, preferably greater than 4 square millimeters, so as to ensure that the impedance between the sheet-shaped conductive medium 310 and the second grounded metal 633 is sufficiently small. In this way, the second circuit path may have lower impedance, so that the impedance between the first grounded metal and the second grounded metal is lower, and therefore, charging/discharging of the first battery 622 and the second battery 632 are more balanced.

In addition, for an implementation in which the sheet-shaped conductive medium 310 is attached to the grounded metal, a height between the sheet-shaped conductive medium 310 and the middle frame may be reduced, so as to reduce impedance between the middle frame and the sheet-shaped conductive medium 310. For example, the height difference between the sheet-shaped conductive medium 310 and the first middle frame 620 may be less than 5 millimeters, thereby ensuring that the impedance between the sheet-shaped conductive medium 310 and the first middle frame 620 is sufficiently small. In addition, the height difference between the sheet-shaped conductive medium 310 and the second middle frame 630 may also be less than 5 millimeters, so as to ensure that the impedance between the sheet-shaped conductive medium 310 and the second middle frame 630 is sufficiently small. In this way, the impedance between the first grounded metal and the second grounded metal may be reduced, and it is ensured that the second current path I₂ may take a good shunting effect on the first current path I₁.

The electromagnetic protection structure 10 provided in this embodiment of this application may be further used in another scenario, for example, may be used in a mobile phone that includes a lifting assembly. The lifting assembly may be, for example, a liftable camera module.

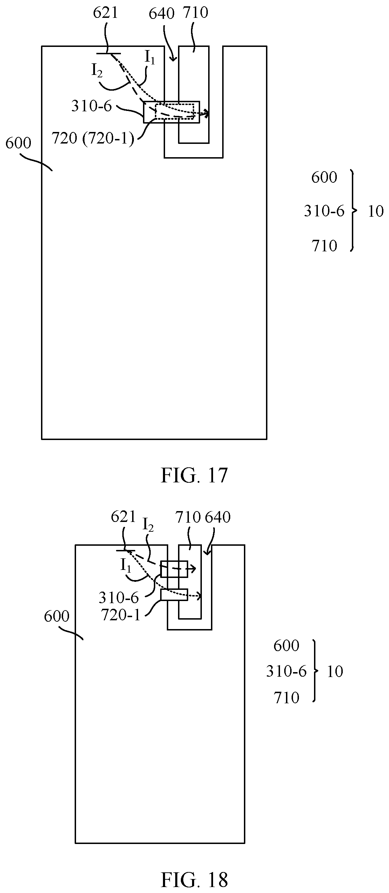

FIG. 17 is a ninth schematic application diagram of an electromagnetic protection structure 10 according to an example embodiment of this application.

As shown in FIG. 17, in a mobile phone including a lifting assembly 710, a middle frame 600 may have a hollowed-out part in communication with an outer edge of the middle frame 600, so as to form a cavity 640 in communication with the outside in the mobile phone. The lifting assembly 710 may be located in the cavity 640. The lifting assembly 710 may be connected to the middle frame 600 of the mobile phone by using one or more drive structures 720. On the one hand, the drive structure 720 has a connection function, and may connect the lifting assembly 710 to the middle frame 600 to avoid shaking of the lifting assembly 710 in the cavity 640. On the other hand, the drive structure 720 further has a driving function, and may drive the lifting assembly 710 to rise or fall relative to the middle frame 600, so that a part of the lifting assembly 710 rises outside the cavity 640 or is hidden in the cavity 640.

As shown in FIG. 17, the mobile phone including the lifting assembly 710 may include a drive structure 720-1. The drive structure 720-1 may be a component having connection and driving capabilities, such as a screw, a motor, a slide rail, a slider, a gear, or a rack, or a combination of a plurality of components. This is not specifically limited herein.

Due to existence of the lifting assembly 710, relative to the lifting assembly 710, the middle frame 600 may include a side close to the first antenna 621 and a side far away from the first antenna 621. One end of the drive structure 720-1 is connected to a side that is of the middle frame 600 and that is close to the antenna, and the other end of the drive structure 720-1 is connected to the lifting assembly 710, and is far away from the first antenna 621 of the mobile phone. Therefore, the coupling current of the first antenna 621 flows from the side that is of the middle frame 600 and that is close the first antenna 621 to the lifting assembly 710 through the drive structure 720-1. It may be understood that there may be unstable contact in the drive structure 720-1 and at a junction between the drive structure 720-1 and the middle frame 600 or the lifting assembly 710.

It can be learned that, in the structure shown in FIG. 17, the drive structure 720-1 forms a first current path I₁ between the middle frame 600 and the lifting assembly 710, and there is a non-linear region in the first current path I₁. The non-linear region may include, for example, an unstable contact region inside the drive structure 720-1, and/or an unstable contact region between the drive structure 720-1 and the middle frame 600, and/or an unstable contact region between the drive structure 720-1 and the lifting assembly 710.

To resolve an electromagnetic compatibility problem caused by a non-linear effect, a sheet-shaped conductive medium 310-6, for example, sheet-shaped metal, may be used to electrically connect the middle frame 600 to the lifting assembly 710, so as to shunt a coupling current in the first current path I₁.

As shown in FIG. 17, in an implementation, one end of the sheet-shaped conductive medium 310-6 may be attached to a side that is of the middle frame 600 and that is close to the first antenna 621, so that an electrical connection and stable contact are formed between the sheet-shaped conductive medium 310-6 and the middle frame 600. The other end of the sheet-shaped conductive medium 310-6 is attached to the lifting assembly 710, so that an electrical connection and stable contact are formed between the sheet-shaped conductive medium 310-6 and the lifting assembly 710. In this way, the middle frame 600 serves as the first structural member 100, the lifting assembly 710 serves as the second structural member 200, the drive structure 720-1 serves as the first connecting member 400, and the sheet-shaped conductive medium 310-6 may form the second current path I₂ between the middle frame 600 and the lifting assembly 710.

In this implementation, the second current path I₂ formed by the sheet-shaped conductive medium 310-6 may shunt the first current path I₁, so as to eliminate or weaken a non-linear effect of a non-linear region on the first current path I₁. Therefore, in this implementation, an electromagnetic compatibility problem of the mobile phone including the lifting assembly 710 that is caused by the non-linear effect can be resolved.

Further, as shown in FIG. 17, in an implementation, the sheet-shaped conductive medium 310-6 may be located in a projection region of the drive structure 720-1, and covers a surface of the drive structure 720-1. On this basis, one end of the sheet-shaped conductive medium 310-6 may extend to the side that is of the middle frame 600 and that is close to the first antenna 621, and is attached to the middle frame 600 by using a conductive adhesive. The other end of the sheet-shaped conductive medium 310-6 may extend to a surface of the lifting assembly 710, and is attached to the lifting assembly 710 by using the conductive adhesive. In this way, in addition to forming electrical connections to the middle frame 600 and the lifting assembly 710, the sheet-shaped conductive medium 310-6 can further form an electrical connection to the drive structure 720-1. Therefore, when the coupling current flows through the drive structure 720-1, the sheet-shaped conductive medium 310-6 may further shunt away a part of the coupling current from the drive structure 720-1, so as to improve a shunting effect of the second current path I₂ on the first current path I₁.

FIG. 18 is a tenth schematic application diagram of an electromagnetic protection structure 10 according to an example embodiment of this application.

As shown in FIG. 18, in an implementation, the sheet-shaped conductive medium 310-6 may be closer to an outer edge of the middle frame 600 than the drive structure 720-1, one end of the sheet-shaped conductive medium 310-6 is attached to a side that is of the middle frame 600 and that is close to the first antenna 621, and the other end of the sheet-shaped conductive medium 310-6 is attached to the lifting assembly 710. In this way, the second current path I₂ may be established in a region in which more coupling currents of the first antenna 621 are distributed, so as to shunt away more coupling currents. In addition, a length of the second current path I₂ may be shortened, so that the length of the second current path I₂ is shorter than a length of the first current path I₁, and impedance of the second current path I₂ is reduced, thereby improving a shunting effect of the second current path I₂ on the first current path I₁.

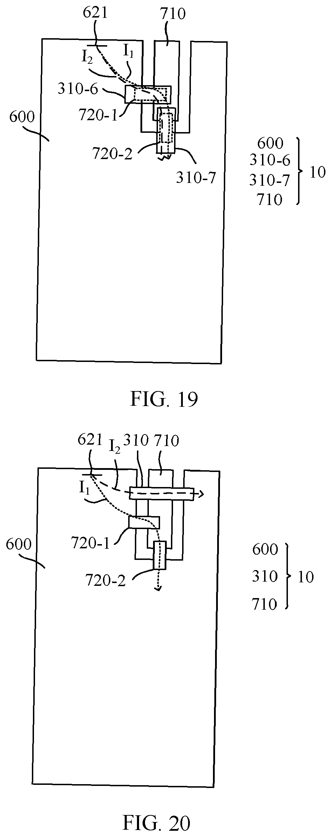

FIG. 19 is an eleventh schematic application diagram of an electromagnetic protection structure 10 according to an example embodiment of this application.

As shown in FIG. 19, the mobile phone including the lifting assembly 710 may further include a drive structure 720-2. The drive structure 720-2 may be a component having connection and driving capabilities, such as a screw, a motor, a slide rail, a slider, a gear, or a rack, or a combination of a plurality of components. This is not specifically limited herein.

One end of the drive structure 720-2 is connected to the lifting assembly 710, and is close to the first antenna 621 of the mobile phone, and the other end of the drive structure 720-2 is connected to the middle frame 600, and is far away from the first antenna 621 of the mobile phone. The entire drive structure 720-2 is further away from the first antenna 621 than the drive structure 720-1. Therefore, the coupling current in the lifting assembly 710 flows to the middle frame 600 through the drive structure 720-2 again. In other words, the drive structure 720-2 forms the first current path I₁ between the lifting assembly 710 and the middle frame 600. When the coupling current passes through the drive structure 720-2, a non-linear effect is also generated, which causes an electromagnetic compatibility problem.

In an implementation, to resolve an electromagnetic compatibility problem caused by the non-linear effect, a sheet-shaped conductive medium 310-7 may be added based on the structure shown in FIG. 17 or FIG. 18. One end of the sheet-shaped conductive medium 310-7 is attached to the lifting assembly 710, and is electrically connected to the lifting assembly 710, so as to form stable contact. The other end of the sheet-shaped conductive medium 310-7 is attached to a side that is of the middle frame 600 and that is far away from the first antenna 621, and is electrically connected to the side that is of the middle frame 600 and that is far away from the first antenna 621, so as to form stable contact. In this way, the lifting assembly 710 serves as the first structural member 100, the side that is of the middle frame 600 and that is far away from the first antenna 621 serves as the second structural member 200, the drive structure 720-2 serves as the first connecting member 400, and the sheet-shaped conductive medium 310-7 may form a second current path I₂ between the lifting assembly 710 and the side that is of the middle frame 600 and that is far away from the first antenna 621.

In this implementation, the second current path I₂ formed by the sheet-shaped conductive medium 310 may shunt the first current path I₁, so as to eliminate or weaken a non-linear effect of a non-linear region on the first current path I₁. Therefore, in this implementation, an electromagnetic compatibility problem of the mobile phone including the lifting assembly 710 that is caused by the non-linear effect can be resolved.

It should be further noted herein that in the electromagnetic protection structure 10 shown in FIG. 17-FIG. 19, the sheet-shaped conductive medium 310 may use a structure that has stretching performance, for example, a metal spring having an S-shaped reciprocating structure. In this way, when the lifting assembly 710 rises or falls, the sheet-shaped conductive medium 310 may be adaptively stretched or restored with rising or falling of the lifting assembly 710 to ensure stable contact with the middle frame 600 and the lifting assembly 710.

FIG. 20 is a twelfth schematic application diagram of an electromagnetic protection structure 10 according to an example embodiment of this application.

As shown in FIG. 20, in an implementation, one end of the sheet-shaped conductive medium 310 may be attached to a side that is of the middle frame 600 and that is close to the first antenna 621, so that an electrical connection and stable contact are formed between the sheet-shaped conductive medium 310 and the side that is of the middle frame 600 and that is close to the first antenna 621. The other end of the sheet-shaped conductive medium 310 is attached to a side that is of the middle frame 600 and that is far away from the first antenna 621, so that an electrical connection and stable contact are formed between the sheet-shaped conductive medium 310 and the side that is of the middle frame 600 and that is far away from the first antenna 621. In this way, the side that is of the middle frame 600 and that is close to the first antenna 621 serves as the first structural member 100, the side that is of the middle frame 600 and that is far away from the first antenna 621 serves as the second structural member 200, the drive structure 720-1, the lifting assembly 710, and the drive structure 720-2 serve as the first connecting member 400, and the sheet-shaped conductive medium 310 may form the second current path I₂ between the middle frames 600 on two sides of the lifting assembly 710.

In this implementation, the second current path I₂ formed by the sheet-shaped conductive medium 310 may shunt the first current path I₁, so as to eliminate or weaken a non-linear effect of a non-linear region on the first current path I₁. Therefore, in this implementation, an electromagnetic compatibility problem of the mobile phone including the lifting assembly 710 that is caused by the non-linear effect can be resolved.

An embodiment of this application further provides an electronic device. The electronic device may be, for example, a foldable-screen mobile phone, a mobile phone with a liftable camera module, or any electronic device that has or may have a non-linear effect. The electronic device may include the electromagnetic protection structure 10 provided in the foregoing embodiments of this application and implementations thereof, so as to resolve an electromagnetic compatibility problem of the electronic device caused by the non-linear effect.

For example, the electronic device includes a first middle frame, a second middle frame, a rotary shaft assembly, a foldable screen, and a sheet-shaped conductive medium. The first middle frame includes a radio frequency source. The first middle frame and the second middle frame are distributed on two sides of the rotary shaft assembly, and are separately connected to the rotary shaft assembly. The foldable screen covers a same side of the first middle frame, the second middle frame, and the rotary shaft assembly. The first middle frame and the second middle frame are configured to be rotatable around the rotary shaft assembly to fold or unfold the foldable screen. A first current path is coupled between the first middle frame and the second middle frame through the rotary shaft assembly. The conductive medium is electrically connected to the first middle frame and the second middle frame to form a second current path between the first middle frame and the second middle frame, so that at least a part of a coupling current of the radio frequency source flows from the first middle frame to the second middle frame through the second current path.

For example, an embodiment of this application provides an electronic device. The electronic device includes a middle frame, a lifting assembly, a drive structure, and a sheet-shaped conductive medium. The middle frame includes a radio frequency source and a cavity, and the lifting assembly is disposed in the cavity. One end of the drive structure is connected to the middle frame, and the other end of the drive structure is connected to the lifting assembly, to drive the lifting assembly to fall or rise, so that the lifting assembly is hidden in the cavity or at least partially protrudes from the cavity. A first current path is coupled between the middle frame and the lifting assembly through the drive structure. The conductive medium is electrically connected to the middle frame and the lifting assembly to form a second current path between the middle frame and the lifting assembly, so that at least a part of a coupling current of the radio frequency source flows from the middle frame to the lifting assembly through the second current path.

It is easy to understand that, on the basis of the several embodiments provided in this application, a person skilled in the art can, for example, combine, split, and reorganize the embodiments of this application to obtain other embodiments, and none of these embodiments exceeds the protection scope of this application.

The objectives, technical solutions, and beneficial effects of this application are further described in detail in the foregoing specific implementations. It should be understood that the foregoing descriptions are merely specific implementations of this application, but are not intended to limit the protection scope of this application. Any modification, equivalent replacement, or improvement made based on the technical solutions of this application shall fall within the protection scope of this application.

## Claims

1. An electromagnetic protection structure, comprising:
a first structural member, wherein the first structural member comprises a radio frequency source;
a second structural member, wherein a first current path is coupled between the second structural member and the first structural member, the first current path comprises a non-linear region, and when a coupling current of the radio frequency source passes through the non-linear region, a non-linear effect is generated in the non-linear region; and
a conductive medium, wherein the conductive medium is electrically connected to the first structural member and the second structural member to form a second current path between the second structural member and the first structural member, so that at least a part of the coupling current of the radio frequency source flows from the first structural member to the second structural member through the second current path.

2. The electromagnetic protection structure according to claim 1, wherein
the non-linear region comprises an unstable contact region between at least two components on the first current path, and relative displacement is capable of being generated between the at least two components forming the unstable contact region.

3. The electromagnetic protection structure according to claim 2,
further comprising a first connecting member, wherein
the first connecting member is electrically connected to the first structural member and the second structural member to form the first current path; and
the non-linear region comprises an unstable contact region between at least two components in the first connecting member, and/or an unstable contact region between the first connecting member and the first structural member, and/or an unstable contact region between the first connecting member and the second structural member.

4. The electromagnetic protection structure according to claim 3, wherein
the conductive medium covers surfaces of the first structural member, the second structural member, and the first connecting member.

5. The electromagnetic protection structure according to claim 3, wherein
a distance between the conductive medium and an edge of the first structural member is less than a distance between the first connecting member and the edge of the first structural member.

6. The electromagnetic protection structure according to any one of claims 3-5, wherein
the electromagnetic protection structure is used in a foldable-screen electronic device;
the foldable-screen electronic device comprises a first middle frame, a second middle frame, and a rotary shaft assembly;
the first middle frame and the second middle frame are distributed on two sides of the rotary shaft assembly;
the first middle frame and the second middle frame are separately connected to the rotary shaft assembly; and
the non-linear region comprises an unstable contact region between at least two components in the rotary shaft assembly.

7. The electromagnetic protection structure according to claim 6, wherein
the first structural member comprises the first middle frame;
the second structural member comprises the second middle frame;
the first connecting member comprises the rotary shaft assembly; and
one end of the conductive medium is attached to the first middle frame, and the other end of the conductive medium is attached to the second middle frame.

8. The electromagnetic protection structure according to claim 6, wherein
the rotary shaft assembly comprises a rotary shaft body, a first rotating structure, and a second rotating structure;
the first rotating structure is located in the rotary shaft body; and one end of the first connecting structure is connected to the first middle frame, and the other end of the first connecting structure is connected to the first rotating structure;
the non-linear region comprises an unstable contact region between at least two components in the first rotating structure, and\or an unstable contact region between the first rotating structure and the first connecting structure;
the first structural member comprises the first middle frame;
the second structural member comprises the rotary shaft body;
the first connecting member comprises the first rotating structure and the first connecting structure; and
one end of the conductive medium is attached to the first middle frame, and the other end of the conductive medium is attached to the rotary shaft body.

9. The electromagnetic protection structure according to claim 6, wherein
the rotary shaft assembly comprises a rotary shaft body, a door panel, a second connecting structure, and a third connecting structure;
one end of the second connecting structure is connected to the first middle frame, and the other end of the second connecting structure is connected to the door panel;
one end of the third connecting structure is connected to the door panel, and the other end of the third connecting structure is connected to the rotary shaft body;
the non-linear region comprises an unstable contact region between the second connecting structure and the door panel, and/or an unstable contact region between the third connecting structure and the door panel;
the first structural member comprises the first middle frame;
the second structural member comprises the rotary shaft body;
the first connecting member comprises the door panel, the second connecting structure, and the third connecting structure; and
one end of the conductive medium is attached to the first middle frame, and the other end of the conductive medium is attached to the rotary shaft body.

10. The electromagnetic protection structure according to claim 6, wherein
the first structural member comprises the first middle frame;
the second structural member comprises the second middle frame;
the first connecting member comprises the rotary shaft assembly; and
the conductive medium comprises a support plate of a foldable screen, a conductive filler is filled between the support plate and the first middle frame and between the support plate and the second middle frame, and the support plate is electrically connected to the first middle frame and the second middle frame separately by using the conductive filler.

11. The electromagnetic protection structure according to any one of claims 3-5, wherein
the electromagnetic protection structure is used in an electronic device that comprises a lifting assembly;
the electronic device comprises a middle frame, the lifting assembly, and a drive structure;
one end of the drive structure is connected to the middle frame, and the other end of the drive structure is connected to the lifting assembly; and
the non-linear region comprises an unstable contact region between at least two components in the drive structure, and/or an unstable contact region between the drive structure and the middle frame, and/or an unstable contact region between the drive structure and the lifting assembly.

12. The electromagnetic protection structure according to claim 11, wherein
the first structural member comprises the middle frame;
the second structural member comprises the lifting assembly;
the first connecting member comprises the drive structure; and
one end of the conductive medium is attached to a side that is of the middle frame and that is close to the radio frequency source, and the other end of the conductive medium is attached to the lifting assembly; or one end of the conductive medium is attached to a side that is of the middle frame and that is close to the radio frequency source, and the other end of the conductive medium spans across the lifting assembly, and is attached to a side that is of the middle frame and that is far away from the radio frequency source.

13. The electromagnetic protection structure according to claim 11 or 12, wherein
the lifting assembly is a liftable camera module.

14. The electromagnetic protection structure according to claim 6, wherein
the first middle frame comprises a first battery and first grounded metal, and the first battery is electrically connected to the first grounded metal;
the second middle frame comprises a second battery and second grounded metal, and the second battery is electrically connected to the second grounded metal; and
one end of the conductive medium is attached to the first grounded metal, and the other end of the conductive medium is attached to the second grounded metal.

15. The electromagnetic protection structure according to any one of claims 1-14, wherein
the conductive medium comprises a sheet-shaped conductive medium.

16. The electromagnetic protection structure according to claim 15, wherein
each of a contact area between the sheet-shaped conductive medium and the first structural member and a contact area between the sheet-shaped conductive medium and the second structural member is greater than 2 square millimeters.

17. The electromagnetic protection structure according to claim 15, wherein
a width of the sheet-shaped conductive medium is greater than 0.5 millimeter, and a thickness of the sheet-shaped conductive medium is less than 4 millimeters.

18. The electromagnetic protection structure according to claim 15, wherein
the sheet-shaped conductive medium is sheet-shaped metal.

19. The electromagnetic protection structure according to any one of claims 1-18, wherein
a length of the second current path is less than a length of the first current path.

20. The electromagnetic protection structure according to any one of claims 1-18, wherein
impedance of the second current path is less than impedance of the first current path.

21. The electromagnetic protection structure according to any one of claims 1-18, wherein
a height difference between the conductive medium and the first structural member or the second structural member is less than 5 millimeters.

22. An electronic device, comprising:
a first middle frame, a second middle frame, a rotary shaft assembly, a foldable screen, and a conductive medium, wherein
the first middle frame comprises a radio frequency source;
the first middle frame and the second middle frame are distributed on two sides of the rotary shaft assembly, and are separately connected to the rotary shaft assembly;
the foldable screen covers a same side of the first middle frame, the second middle frame, and the rotary shaft assembly;
the first middle frame and the second middle frame are configured to be rotatable around the rotary shaft assembly to fold or unfold the foldable screen; and
a first current path is coupled between the first middle frame and the second middle frame through the rotary shaft assembly; and the conductive medium is electrically connected to the first middle frame and the second middle frame to form a second current path between the first middle frame and the second middle frame, so that at least a part of a coupling current of the radio frequency source flows from the first middle frame to the second middle frame through the second current path.

23. An electronic device, comprising:
a middle frame, a lifting assembly, a drive structure, and a conductive medium, wherein
the middle frame comprises a radio frequency source and a cavity, and the lifting assembly is disposed in the cavity;
one end of the drive structure is connected to the middle frame, and the other end of the drive structure is connected to the lifting assembly, to drive the lifting assembly to fall or rise, so that the lifting assembly is hidden in the cavity or at least partially protrudes from the cavity; and
a first current path is coupled between the middle frame and the lifting assembly through the drive structure; and the conductive medium is electrically connected to the middle frame and the lifting assembly to form a second current path between the middle frame and the lifting assembly, so that at least a part of a coupling current of the radio frequency source flows from the middle frame to the lifting assembly through the second current path.
